(19) Europäisches Patentamt
European Patent Office
Office européen des brevets

(11) EP 1 189 497 A2

(12) **EUROPEAN PATENT APPLICATION**

(43) Date of publication:
**20.03.2002 Bulletin 2002/12**

(51) Int Cl.$^7$: **H05K 13/08**

(21) Application number: **01122267.6**

(22) Date of filing: **18.09.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **18.09.2000 JP 2000282440**
**26.09.2000 JP 2000292148**

(71) Applicant: **MATSUSHITA ELECTRIC INDUSTRIAL CO., LTD.**
**Kadoma-shi, Osaka-fu (JP)**

(72) Inventors:
- **Hada, Junichi**
  **Nakakoma-gun, Yamanashi-ken (JP)**
- **Fukuda, Shozo**
  **Nakakoma-gun, Yamanashi-ken (JP)**
- **Imafuku, Shigeki**
  **Nakakoma-gun, Yamanashi-ken (JP)**
- **Noudo, Akira**
  **Nakakoma-gun, Yamanashi-ken (JP)**
- **Hattori, Yoshiyuki**
  **Kofu-shi, Yamanashi-ken (JP)**

(74) Representative: **Eisenführ, Speiser & Partner**
**Martinistrasse 24**
**28195 Bremen (DE)**

# (54) Apparatus and method for mounting components on substrate

(57) An apparatus has a holder that receives a component from a component supply and then places the component on a substrate. In operation, it is determined whether the holder makes an interference with another component mounted on the substrate. If the judgement is affirmative, an mounting of the component held by the holder is prohibited. If, on the other hand, the judgement is negative, the component held by the holder is mounted on the substrate.

*Fig.1*

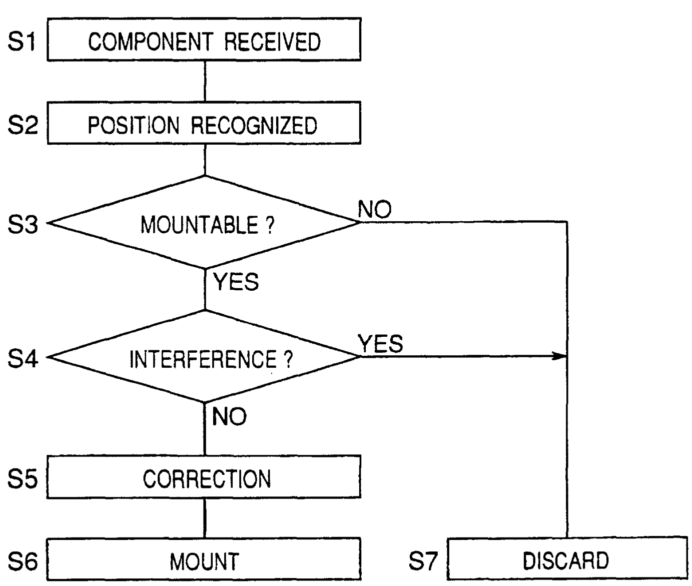


EP 1 189 497 A2

Printed by Jouve, 75001 PARIS (FR)

**Description**

FIELD OF THE INVENTION

The present invention relates to an apparatus and method for mounting electric components on a substrate such as circuit board.

BACKGROUND OF THE INVENTION

Referring to Fig. 31, there is illustrated a conventional mounting apparatus generally indicated by reference numeral 1. In general, the system 1 includes a supply section 2 for supplying electric components to the system 1, a placement head 3 for receiving the component from the supply section 2 and then mounting the component on a substrate such as circuit board, a transport unit 4 for transporting the placement head 3, a recognition device 5 for taking a digital image of the component held by the placement head 3, a holding section 6 for receiving and holding the substrate onto which the components are mounted, and a controller 7 for controlling an entire operation of the system 1.

In operation of the system 1, the placement head 3 moves to a predetermined position above the supply section 2 bearing a component supply cassette 11, for example, with a number of components 12. A vertically extending vacuum nozzle 13 in the form of quill supported by the placement head 3 is moved down to receive the component 12. The placement head 3 is then rotated about a vertical axis, i.e. Z-axis, by an angle controller 14 so that the component is oriented in a predetermined direction. The recognition device 5 takes an image of the component 12 supported by the nozzle 13 of the placement head 13 moving past a predetermined position opposing the image processor 5. The image is transmitted to an image processor 20 where the image is processed according to a specific image processing technique to determine a position of the component, i.e., its horizontal and/or angular displacement relative to the nozzle. Information indicating the position of the component is transmitted to the controller 7. Based upon the information, the controller 7 corrects the position of the component. Then, the nozzle 13 is moved above a predetermined placement position of the substrate 18 and then down toward the substrate 18 so that the component 12 is mounted on the substrate.

Fig. 32 is a flowchart showing a conventional method for mounting components. In this method, at step S1101, the nozzle 13 receives the component 12. Then, at step S1102, the recognition device 5 takes a picture of the component 12 held by the nozzle 13. The picture is processed at the image processor 20. The position of the component 12 is determined at step S1103 whether the component 12 can be mounted on the substrate. If the component 12 is incapable of being mounted on the substrate, the nozzle 13 brings the component to a collect station (not shown) at step S1106. Otherwise, the horizontal and/or angular displacement of the nozzle 13 is determined at step S1104. Using the displacement, the horizontal position of the placement head 3 and/or the angular orientation of the nozzle 13 is adjusted. Finally, the component 12 is mounted in position onto the substrate 18 at step S1105. In this process, no judgement is made whether the nozzle 13 interferes with one or more components mounted on the substrate 18.

In the meantime, the electric devices are likely to be small sized and light-weighted, increasing a density of components mounted on the substrate 18 considerably. For example, a clearance between neighboring components of about 1.0mm x 0.5mm is decreased to about 0.2mm. Notwithstanding this, each component should be mounted on the substrate as it does not interfere with another component mounted on the substrate. To this end, used is the nozzle with a tip end designed to be larger than the small component 12.

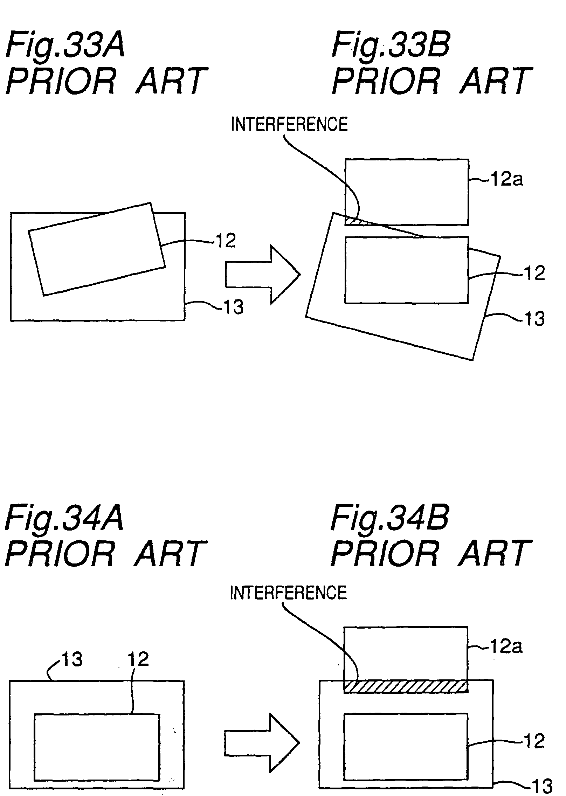

However, where the clearance of the components is down to about 0.1mm, for example, a displacement of the component 12 relative to the nozzle 13 may result in an interference between the nozzle 13 and the component 12 mounted on the substrate 18. This is illustrated in Figs. 33A to 34B. In each drawing, illustrated are nozzle 13 and components 12, both viewed from the substrate. Specifically, in Fig. 33A, the nozzle 13 is shown so that it is angularly inclined to the component 12. In this instance, using the image of the component captured by the recognition device 5 and the result obtained by the image processor 20, the controller 7 corrects the horizontal and/or angular position of the component 12 relative to the nozzle 13 before the mounting of the component 12 so that the component is placed on a predetermined, correct position on the substrate. However, as shown by hatched lines in Fig. 33B, a part of the nozzle can result in an interference with another component 12a mounted on the substrate. On the other hand, Fig. 34A shows the nozzle and the component retained by the nozzle in which the component is horizontally offset from a center of the nozzle. In this instance, as shown in Fig. 34B, the nozzle 13 is displaced so that the component is mounted on a correct position on the substrate and this in turn results in an interference with another component 12a mounted on the substrate as shown by hatching.

Although not clearly shown in the plan views, i.e., Figs. 33B and 34B, since the component has a certain height, the interference may be more problematic for the case with a reduced clearance when considering a deviation of height and/or inclination of the component. That is, the interference between the nozzle 13 and the component 12a results in another displacement of the component 12a. What is worse, the component 12 may be damaged, which results in a deterioration and/or malfunction of the circuit.

## SUMMARY OF THE INVENTION

Therefore, a purpose of the present invention is to provide an apparatus and method for mounting component on a substrate, which is capable of mounting component on the substrate without any interference between the nozzle and the component mounted on the substrate even when only a small clearance is ensured between the components on the substrate due to a requirement of compactness of the component.

To this end, according to the apparatus and method of the present invention, a holder receives a component from a component supply and then places the component on a substrate. In operation, a judgement is made whether the holder makes an interference with another component mounted on the substrate. Then, if the judgement is affirmative, an mounting of the component held by the holder is prohibited. If, on the other hand, the judgement is negative, the component held by the holder is mounted on the substrate.

## BRIEF DESCRIPTION OF THE DRAWINGS

Fig. 1 is a flowchart showing a method for mounting components on a substrate according to a first embodiment of the present invention;
Fig. 2 is a flowchart showing a method for mounting components on a substrate according to another embodiment of the present invention;
Fig. 3 is an enlarged side elevational view showing heights of the components mounted on the substrate;
Figs. 4A and 4B are diagrams for describing a determination of an interference between a component holder and the component mounted on the substrate;
Fig. 5 is a flowchart showing a method for mounting components on a substrate according to another embodiment of the present invention;
Figs. 6A and 6B are diagrams for describing a determination of the interference according to the method in Fig. 5;
Fig. 7 is a flowchart showing a method for mounting components on a substrate according to another embodiment of the present invention;
Figs. 8A to 8C are diagrams for describing a determination of the interference according to the method in Fig. 7;
Figs. 9A to 9C are another diagrams for describing a determination of the interference;
Fig. 10 is a schematic perspective view of the component mounting apparatus of the present invention;
Fig. 11 is a flowchart showing a method for mounting components on a substrate according to another embodiment of the present invention;
Figs. 12A and 12B are diagrams for describing a determination of the interference according to the method in Fig. 11;
Fig. 13 is a flowchart showing a method for mounting components on a substrate according to another embodiment of the present invention;
Fig. 14 is a flowchart showing a method for mounting components on a substrate according to another embodiment of the present invention;
Fig. 15 is a schematic perspective view of another component mounting apparatus of the present invention;
Fig. 16 is a side elevational view showing a part of the component mounting apparatus with a rotary head;
Fig. 17 is a plan view showing an arrangement of placement heads supported by the rotary head;
Fig. 18 is a block diagram showing portions of a controller of the component mounting apparatus;
Fig. 19 is a table showing an example of an NC program;
Fig. 20 is a table showing an example of an arrangement program;
Fig. 21 is a table showing an example of a parts library;
Fig. 22 is a flowchart showing a process for calculating a neighboring distance carried out at distance calculator in Fig 18;
Fig. 23 is a diagram showing an area occupied by the component on the substrate;
Fig. 24 is a diagram showing a distance between the neighboring areas;
Fig. 25 is a flowchart for determining the interference between the holder and the component;
Fig. 26 is a flowchart showing processes carried out at the component data section;
Fig. 27 is a perspective view of another component mounting apparatus;
Fig. 28 is a block diagram showing portions of the component mounting apparatus;
Fig. 29 is an enlarged perspective view of the placement heads of the component mounting apparatus;

Fig. 30 is a schematic plan view of the component mounting apparatus in Fig. 29;
Fig. 31 is a schematic perspective view of the conventional component mounting apparatus;
Fig. 32 is a flowchart showing a conventional component mounting process; and
Figs. 33A and 33B are schematic plan views for describing the interference between the holder and the component.

## DETAILED DESCRIPTION OF THE PREFERRED EMBODIMENTS

### FIRST EMBODIMENT

With reference to the drawings, descriptions will be made to a system and method for mounting a component onto a substrate or circuit board according to the first embodiment of the present invention. The system of the present invention has an appearance that is substantially identical to the conventional system illustrated in Fig. 31. Namely, the system 1 has a component supply 2, a placement head 3 for receiving and mounting, a robot or transport device 4 for transporting the placement head 3, a recognition device 5 for taking a picture of the component held by the placement head, a holder 6 for receiving and then holding the substrate, and a controller 7 for controlling an entire operation of the system.

Generally, the placement head 3 causes its nozzle 13 to receive the component 12 from the component supply 2 and, while moving toward the recognition device 5, rotate the nozzle about its vertical axis so that the component orients in a predetermined mounting direction. The recognition device 5 takes a picture of the component held by nozzle 13 of the placement head 3. The picture is then processed by the image processor 20 to determine the position of the component 12 on the nozzle 13. The determined position is transmitted to the controller 7. Based upon an instruction from the controller 7, the placement head 3 corrects, if any, horizontal and/or angular displacement of the component and then places the component in a predetermined area on the substrate 18. Typically, the picture of the component is taken while the placement head 3 is moving toward the placement station. However, according to the type of the recognition device 5, the placement head 3 may halt while taking the picture of the component.

Fig. 1 is a flowchart showing a process for mounting a component according to an embodiment of the present invention, which is carried by the controller 7. According to this program, at step S1 the component 12 is received by nozzle 13 of the placement head. At step S2 the recognition device 5 picks up an image of the component held by nozzle. The image is transmitted to and then processed by the image processor 20. Using a result obtained by the image processor 20, it is determined at step S3 whether the component can be mounted on the substrate. If it is determined that the component is incapable of being mounted correctly on the substrate, the program proceeds to step S7, causing the nozzle 13 to discard the component at a collect station not shown. This occurs where the component is considerably inclined to a surface of the substrate; the nozzle bears an incorrect component; or the component is outside the field of the recognition device so that the recognition device is unable to pick up the whole image of the component.

If it is determined at step S3 that component is in the condition that it can be mounted on the substrate, the program proceeds to step S4. At this step, another determination is made whether, during the mounting of the component, the nozzle 13 makes an interference with the component mounted on substrate due to the horizontal and/or angular adjustment of the component relative to the nozzle. This determination will be described fully together with the specific embodiments. If, on the other hand, it is determined at step S4 that there exists a possibility of the interference between the nozzle 13 and the component 12a mounted on the substrate, the program proceeds to step S7. At this step, the component 12 held by the nozzle 13 is discarded at the collect station not shown. Indeed, there exists another option in which the nozzle 13 is moved and/or rotated to a certain extent in order to avoid the interference at the mounting of the component 12, which will be described in detail below. Then, the program proceeds to step S5 where a horizontal and/or angular correction of the nozzle 13 required for the mounting of the component 12 is determined. Subsequently, the nozzle 13 is corrected and then the component 12 is mounted on the substrate 18 at step S6. After the completion of the mounting or the discard of the component, the nozzle 13 moves again toward the component supply 2 for the next pickup operation of the component. The above steps are repeated for the subsequent components to be mounted on the substrate.

### SECOND EMBODIMENT

Next, referring to the drawings, descriptions will be made to the component mounting apparatus and method according to the second embodiment of the present invention. Basically, the structure of appearance and operation of the system of this embodiment is similar to that of the first embodiment described above, except for a process for the prevention of the interference between the nozzle and the component.

Referring to Fig. 2, there is a process performed by the controller 7. In this process, the component 12 is supported on the nozzle at step S11. Then, a position of the component 12 held by the nozzle is determined at step S12, which is used for another determination at step S13 whether the component can be mounted on the substrate. If it is determined at step S13 that the component is unable to be mounted on the substrate in a proper way, the program proceeds to step S19 where the component is discarded at the collect station. The operations described above are the same as those described for the first embodiment.

If, on the other hand, it is determined at step 13 that the component is held so that it can be mounted on the substrate, another determination is made at step S14. At this step, it is determined whether the nozzle 13 makes an interference with the component 12a mounted on the substrate at the placement of the component 12 held by the nozzle 13. For this purpose, a first decision is made whether a height of the component 12 held by the nozzle 13 is greater than that of the component 12a around which the component 12 will be mounted. Fig. 3 illustrates a spatial relationship between the component 12 held by the nozzle and the component 12a mounted on the substrate. As shown in the drawing, if the height of the component 12 to be mounted is equal to or more than that of the mounted component 12a, no physical interference between the nozzle 13 and the mounted component 12a will occur even when the nozzle 13 overlaps the mounted component 12a in a region indicated by $\alpha$. The heights of the components 12 and 12a are transmitted to and then stored in the controller 7 (see Fig. 31). Therefore, in this instance the program proceeds to step S17 where a horizontal and/or angular correction of the nozzle is determined in order to mount the component 12 in a predetermined position on the substrate. Based upon this determination, the component 12 is placed on the substrate 18 at step S18.

If, on the other hand, the height of the component 12 is less than that of the mounted component 12a, a calculation is made to determine a relationship between the nozzle 13 and the mounted component 12a, i.e., whether the nozzle 13 makes an interference with the mounted component 12a.

Figs. 4A and 4B schematically illustrate a spatial relationship between the nozzle 13 and the component 12 held by the nozzle in which it is assumed that the component 12 is improperly inclined to the nozzle. In this instance, according to the conventional technique, as best shown in Figs. 4A and 4B, the nozzle 13 is turned around to direct the component in a proper direction, which in turn can result in an interference between the nozzle 13 and the mounted component 12a.

However, according to the present invention, a new concept or reference area (safety region) 21 is used for determining whether the nozzle interferes with the mounted component. The reference area 21 is predetermined in light of the position of the neighboring, mounted component 12a. In this embodiment, an outer periphery of the mounted component 12a defines a part of an outline of the reference area 21. Alternatively, as shown by a long and short dotted line in Fig. 4B, the reference area may be spaced away from the outer periphery of the mounted component, leaving a certain clearance therebetween for safe.

An amount of horizontal and/or angular correction of the component relative to the nozzle in Fig. 4A is calculated in light of a known configuration and reference position of the nozzle. Also, the actual displacement of the component is determined by comparing the image of the component taken by the recognition device and the known configuration and reference position of the nozzle. The reference position of the nozzle 13, which is supposed with its center located at the center 25 of the nozzle 13 as shown in Fig. 4A, is stored in the controller 7 or the imaging device 20. Also, in order to suppose the reference area 21, also used are a shape, size and position of the component 12a mounted on the substrate, stored in the controller 7.

Referring back to Fig. 2, using the calculation result made at step S15, a determination is made at step S16 whether the nozzle 13 stays within the reference area 21. When even a small part of the nozzle 13 positions outside the reference area, it is determined that the nozzle 13 interferes with the mounted component 12a. Then, at step S19 the component 12 is discarded from the nozzle 13 without being mounted on the substrate. If, on the other hand, the nozzle 13 stays fully within the reference area 21, it is determined that no interference occurs between the nozzle and the mounted component 12a. Then, the program proceeds to step S17 where the horizontal and/angular displacement or the amount of correction of the component 12 is calculated. Based upon this calculation, the displacement of the component 12 is removed by moving the nozzle 13. Then, the component 12 is placed on the substrate at step S18. After the completion of the placement or discard of the component at step S18 or S19, the nozzle moves back to the supply section 2 for the next pickup operation of the component. Afterwards, the program returns to step S11 so that the above-described procedures are performed again.

A clearance between the reference area 21 and the outline of the mounted component may vary from one direction to the other direction depending upon the features of the neighboring components. Also, the reference area 21 may be extended in one direction in the form of strip if no neighboring component exists in that direction and, therefore, there is no necessity for considering the possible interference in that direction.

If the component held by the nozzle has a greater height than the neighboring, mounted component, it can determine that there is no interference between the nozzle and the mounted component. Therefore, in this instance, the controller performs only steps S13 to S15 for every component without making any determination at step S14. This also applies to the following embodiments.

THIRD EMBODIMENT

Referring to the drawings, descriptions will be made to another system and method according to the third embodiment of the present invention. The basic structure of appearance and operation of the system of this embodiment is similar to that of the first embodiment described above, except for a process for the prevention of the interference between the nozzle and the component.

Referring to Fig. 5, there is shown a process performed by the controller 7. In this process, at step S21, the component 12 is received on the nozzle. Then, a position of the component 12 held by the nozzle is recognized at step S22, which is used for another determination at step S23 whether the component can be mounted on the substrate. If it is determined at step S23 that the component is unable to be mounted on the substrate in a proper way, the program proceeds to step S29 where the component is discarded at the collect station. The operations described above are the same as those described for the first embodiment.

If, on the other hand, it is determined at step 23 that the component is held so that it can be mounted on the substrate, another determination is made at step S24. At this step, it is determined whether a height of the component 12 held by the nozzle 13 is greater than that of the component 12a around which the component 12 will be mounted. If the height of the component 12 to be mounted is equal to or more than that of the mounted component 12a, the program proceeds to step S27 where a horizontal and/or angular correction of the nozzle is calculated. Based upon this calculation, the component 12 is placed on the substrate 18 at step S28.

If, on the other hand, the height of the component 12 is less than that of the mounted component 12a, the program proceeds to step S25 where a position of the nozzle 13 above the substrate 18 at the mounting of the component 12 is calculated. For example, if the component 12 is inclined to the substrate 18 as shown in Fig. 6A, calculated are possible positions of the nozzle 13 on the substrate 18 in which the component 12 is oriented in the proper direction as shown in Fig. 6B.

Based upon this calculation, another determination is made at step S26 whether the nozzle 13 overlaps at least in part the component 12a which is supposed to have been mounted in a predetermined position on the substrate 18. If the overlap is established, it is determined that the nozzle 13 interferes with the mounted component 12a. In this instance, the component 12 is transported to the discard station at step S29 without being mounted on the substrate. Otherwise, the program proceeds to step S27 where an amount of horizontal and/or angular correction of the placement head 3 is calculated. Based upon this calculation, a necessary horizontal and/or angular correction is made to the placement head 3. Then, the component 12 is mounted on the substrate 18. After the mount or discard of the component 12, the nozzle 13 is returned to the supply section 2 for the pickup operation of the subsequent component and, then, the program proceeds again to step S21.

As described above, although in the second embodiment the reference area is considered for the determination of the interference, in this embodiment the interference is determined using the position in which the neighboring component 12a is supposed to have been mounted on the substrate. For this purpose, information of not only the shape and size of the nozzle 13 but also the shape and size and the mounted position of the component 12a are stored in the controller 7. Using this information, the controller 7 calculates the positions occupied by the nozzle 13 and the component 12a.

FOURTH EMBODIMENT

Next, referring to the drawings, descriptions will be made to another component mounting apparatus and method according to the fourth embodiment of the present invention. The basic structure of appearance and operation of the system of this embodiment is similar to that of the first embodiment described above, except for a process for the prevention of the interference between the nozzle and the component.

Referring to Fig. 7, there is shown a process performed by the controller 7. In this process, at step S31, the component 12 is received on the nozzle. Then, a position of the component 12 held by the nozzle is recognized at step S32, which is used for another determination at step S33 whether the component can be mounted on the substrate. If it is determined at step S33 that the component is unable to be mounted on the substrate in a proper way, the program proceeds to step S39 where the component is discarded at the collect station. The operations described above are the same as those described for the first embodiment.

If, on the other hand, it is determined at step 33 that the component is held so that it can be mounted on the substrate, another determination is made at step S34. At this step, it is determined whether a height of the component 12 held by the nozzle 13 is greater than that of the component 12a around which the component 12 will be mounted. If the height of the component 12 to be mounted is equal to or more than that of the mounted component 12a, the program proceeds to step S37 where an amount of horizontal and/or angular correction of the placement head 3 is calculated. Based upon this calculation, the component 12 is placed on the substrate 18 at step S38.

If, on the other hand, the height of the component 12 is less than that of the mounted component 12a, the program proceeds to step S35 where, as shown in Fig. 8B, irrespective of the size of the mounted component 12a, an reference area 21a is determined from the size of the component 12 in an image processing so that it is greater than the size of the component 12 by a certain length. A size of the expanded area of the reference area can be determined arbitrarily. The size of the reference area may be determined using a predetermined limit distance from the neighboring component, stored in the controller as shown in Fig. 21.

Referring back to Fig. 7, it is determined at step 36 whether the nozzle 13 stays within the reference area 21a in light of size and shape of the nozzle 13, the reference position of the nozzle 13 (e.g., its center 25), and the position of the component 12 relative to the nozzle 13 determined at step S32. If not, the program proceeds to step S39 where the component 12 is discarded at the collect station. Otherwise, the program proceeds to step S37 where an amount of horizontal and/or angular correction of the placement head 3 is calculated. Based upon this calculation, a horizontal and/or angular correction is made to the placement head 3. Then, the component 12 is mounted on the substrate 18 at step S38. After the mount or discard of the component 12, the nozzle 13 is returned to the supply section 2 for the pickup operation of the subsequent component and, then, the program proceeds again to step S31.

The size of the reference area 21a may be varied from one direction to the other direction according to the arrangement of the components on the substrate, in particular, neighboring component or components. Also, the reference area 21a may be extended in a certain direction in the form of strip if no neighboring component exists in that direction and, therefore, there is no necessity for considering the possible interference in that direction. Further, if there is a possible interference only in one direction, as shown in Fig. 8C the reference area may be defined only in that direction.

In the embodiments described above, the amount of horizontal and/or angular displacement of the component 12 relative to the nozzle 13 is determined by comparing the known shape and size and the preset reference holding position of the nozzle 13 (e.g., the center of the nozzle 13) with the image picked up by the recognition device 5. However, instead of using such known shape and size arid the preset reference holding position of the nozzle 13, they may be determined from the image picked up by the recognition device 5 and then used for the position determination. This also ensures a precise determination whether there is a possible interference between the nozzle 13 and the mounted component 12a.

Also, in the previous embodiments whether the nozzle 13 interferes with the mounted component 12a is determined by the image processor 20, it may be performed by the controller 7.

Further, although in the previous embodiments the placement head 4 is transported in a horizontal plane by the robot 4, a rotary mounting device having a plurality of placement heads arranged on a circle and rotating successively for mounting may be used instead.

FIFTH EMBODIMENT

Referring to the drawings, descriptions will be made to the system and method according to the fifth embodiment of the present invention. In this embodiment, the system has another imaging device for picking up an image of the substrate 18 in order to establish the position of the component 12a mounted on the substrate and thereby to determine a possible interference between the nozzle 13 and the mounted component 12a. For example, as shown in Fig. 9A, in the previous embodiment it is determined whether the nozzle 13 of which horizontal and/or angular position has been adjusted falls at least in part in the reference area 22 defined by the position of the mounted component 12a. However, a certain condition may be thought that as shown in Fig. 9B the component 12a is mounted on the substrate in an inclined fashion with respect to a predetermined direction and position. In this instance, even though the nozzle 13 stays within the reference area 22, there still exists some possibility to cause the interference between the nozzle 13 and the mounted component 12a. However, when the component 12a is inclined in the opposite direction as shown in Fig. 9C, no interference would occur even if a part of the nozzle 13 is located outside the reference area 22.

Therefore, according to this embodiment, the position of the mounted component 12a is obtained and then used in the determination whether the nozzle 13 interferes with the mounted component 12a. For this purpose, as shown in Fig. 10, a component mounting apparatus 30 has a second image processor 31 for recognition of the component 12a mounted on the substrate 18. Preferably, the image processor 31 is positioned on the placement head 3 near the nozzle 13. Other structures of the system 30 are similar to or identical to those described in the previous embodiment, so that no description is made thereto.

Referring to Fig. 11, there is shown a flowchart indicating a component mounting process performed by the controller 7. The flowchart is similar to that described with respect to the second embodiment, except that the image processor 31 recognizes the position of the component 12a mounted on the substrate 18 at step S41. The recognition is carried out after the placement head 3 has reached a position where it places the component 12 on the substrate 18, preferably after the completion of the placement of the component 12. The image of the mounted component 12a is transmitted to the image processor 20 or the controller 7 where it is used at step S47 to define the reference area.

For example, as shown in Fig. 9D, a deformed reference area 22a may be defined for the inclined component 12a. The deformed reference area 22a ensures to prevent the interference between the nozzle 13 and the component 12a placed improperly. Also ensured is a proper mounting of the component 12 which would be prohibited from being mounted when supposing a non-deformed reference area as shown in Figs. 9A to 9C. The image processor 31 may be provided on another moving member rather than the placement head 3. In this instance, the image processor 31 with the moving member may oppose the substrate 18 for the recognition of the substrate 18 while the placement head 3 is away from substrate 18.

SIXTH EMBODIMENT

Referring to the drawings, descriptions will be made to another system and method according to the sixth embodiment of the present invention. In this embodiment, the component 12 which is discarded due to the possible interference between the nozzle and the mounted component is allowed to be mounted on the substrate 18 by adjusting the horizontal and/or angular position of the nozzle while preventing the interference of the nozzle and the mounted component. That is, in the second embodiment, as shown in Fig. 4B if the nozzle 13 protrudes beyond the reference area 21, the component 12 is discarded without being mounted on the substrate 18. However, as shown in Figs. 11A and 11B, even in the same condition the nozzle 13 rotates in a direction indicated by arrow 27 so that it stays wholly within the reference area 21, allowing the component 12 to be mounted on the substrate 18. This not only prevents the interference between the nozzle and the component on the substrate but also increases an efficiency of the mounting.

Although in the previous embodiment the nozzle 13 is rotated into the reference area, it may be transported linearly in a direction away from the component 12a on the substrate 18. Also, the rotational movement may be combined with the liner movement.

The above adjustment of the nozzle 13 can cause the component 12 to incline as indicated by the solid line, relative to the proper position on the substrate indicated by the long and short dotted line 12b. This may increase a likelihood of the interference between the component 12 mounted on the substrate and the nozzle 13 in the placement movement for the subsequent component. However, the interference is prevented by reducing a size of the reference area 21 according to the inclination in the formation of the region for the subsequent component. The nozzle 13 is discarded unless the nozzle 13 enters entirely within the reference area.

Fig. 13 is a flowchart showing the component mounting method of this embodiment. In this flowchart, processes performed at steps S11 to S19 are the same as that described with regard to the second embodiment of the present invention. If it is determined at step S16 that the nozzle 16 is outside the reference area, another determination is made at step S61 whether the nozzle would be entirely entered within the reference area by the liner and/or rotational movement of the nozzle. If the result is affirmative, the position of the nozzle is adjusted at step S17 so that the nozzle entirely stays within the region. Then, the component held by the nozzle is mounted on the substrate at step S18. Otherwise, the component 12 is discarded at the collect station.

Although this embodiment has been described in combination with the second embodiment, it can equally be combined with another embodiments described above using the reference area. In particular, in the combination of this embodiment with the fifth embodiment, since the interference is determined after the recognition of the position of the component 12a on the substrate, the inclination of the component 12 provides no adverse affect to the mounting of the subsequent component.

SEVENTH EMBODIMENT

Referring to a flowchart in Fig. 14, descriptions will be made to another system and method according to the seventh embodiment of the present invention. In this embodiment, data of interference between the nozzle 13 and the component 12a on the substrate 18 is collected in the process of mountings for one or more certain number of substrates. Then, the collected data is used for the protection of the interference in the subsequent mountings. For example, in mountings for the predetermined number of substrates, interference data including the number, the degree, and position of interference caused between the nozzle and the component is memorized. The data is processed statistically, for example, to obtain a tendency of interference or inclination. This tendency shows, for example, when and/or where the interference is likely to occur. Therefore, if that tendency is confirmed at step S72, an adjustment is made to cancel or reduce the tendency, preventing the interference between the nozzle 13 and the component 12a on the substrate 18.

The adjustment may be made by the rotation and/or horizontal movement of component 12 to be mounted and/or 12a mounted on the substrate. If, by the adjustment, the former tendency is eliminated but another tendency is appeared in the predetermined number of subsequent mountings, a further adjustment is made to cancel or reduce the latter tendency. In this instance, the adjustment may be made to either of two components 12 and 12a alternatively or both. When adjusting both components, the amount of adjustment may be divided substantially equally for two components.

EIGHTH EMBODIMENT

Referring to the drawings, descriptions will be made to another system and method according to the eighth embodiment of the present invention. As described with reference to Fig. 3, when the height of the mounting component 12 is greater than that of the mounted component 12a, no interference occurs between the nozzle 13 and the mounted component 12a. This in turn means that no interference is made by mounting components in an order in which the lower component is mounted earlier than the higher component. Therefore, according to this embodiment, the components are mounted in the reverse order of height, preventing the interference of the nozzle and the mounted component or components without any necessity of defining the reference area or of recognizing the size of the mounted component.

In this case, it is not necessary to determine the mounting order for all components to be mounted on the same substrate. This is because the nozzle 13 may interfere only with the component 12a positioned in an area in which the component 12 will be mounted and may not interfere with the component 12a positioned away from the area. Then, it is advantageous to define several blocks on the substrate, each of which block including only components that would cause the interference between the nozzle and the mounted component. In this instance, the order of mounting of the components is determined for each block. Also, it is unnecessary to determine the interference between the nozzle holding the component to be mounted in one block and the mounted component or components in another block away from one block. Each height of the components to be mounted on one substrate is available from component data pre-stored in the controller 7.

NINTH EMBODIMENT

Referring to the drawings, descriptions will be made to another system and method according to the ninth embodiment of the present invention. In this embodiment, the interference determination using the reference area 21 is performed to the rotary type component mounting apparatus.

As shown in Figs. 15 and 16, the component mounting apparatus 100 generally includes a component supply section 110 for supplying electronic components successively, a rotary head 112 for receiving and then mounting the components on a substrate 18, and an X-Y table 114 for positioning the substrate 18. With this arrangement, the substrate 18 is supplied from a substrate supply section 116 and then positioned on the X-Y table 114. The rotary head 112, on the other hand, receives the components 12 from the component supply section 110. A position of each component on the rotary head 112 is corrected, if necessary. The corrected component is then mounted on the substrate 18. After the completion of the mountings of the components, the substrate is transported from the X-Y table to a substrate discharge station 118.

In addition, the system 100 has an input section 120 for the data input, a display station 122 for the data display, and a controller 107 for controlling operations of the devices in the system. The input data includes sizes of the components and control data and the display data includes data showing the condition of the devices in the system.

Referring to Fig. 16, the component supply section 110 has a set of parallel parts cassettes 11 each holding a number of electronic components 12. The set of parts cassettes is supported so that it can move back ard forth in a direction perpendicular to the drawing, which ensures each of the parts cassettes to provide its component for a component supply region 110a. The X-Y table 114 is supported so that it moves between the substrate supply section 116 and the substrate discharge section 118. At the substrate supply section 116, the table 114 reaches a position communicated with a substrate inlet where it receives the substrate on which the components will be mounted. Then, the table 114 holds and then transports the substrate 18 into a placement position where the components are mounted thereon by the rotary head 112. At the placement position, the table 114 moves left to right and back and forth so that each component is mounted on a predetermined, corresponding position on the substrate. After the completion of the mountings of the components, the table 114 moves to a position adjacent to the substrate discharge section 118 for the discharge of the substrate to the substrate discharge station 118.

For example, as shown in Fig. 17, the rotary head 112 has 12 placement heads at regular intervals on its periphery. Each of the placement heads 126 has five nozzles 132 for holding components of different sizes and is supported so that it moves up and down and rotates about a central, vertical axis thereof. This allows that, when catching and mounting the component, each nozzle 132 takes an outermost position on a circle indicated by long and short dotted line in Fig. 17.

In operation, each placement head 126 is transported by the index rotation of the rotary frame 128 from component supply position 110a of the component supply section 110 to an opposite, component placement position and then back again to the component supply position 110a through various stations.

Discussions will be made to operations carried out at each station. At station 1 (ST1), i.e., drawing station, the nozzle 132 faces the component supply position and receives the component 12 from component supply section 110. Then, the thickness of the component held by the nozzle 132 is measured at ST3 by a two-dimensional line sensor not shown, which is then transmitted to the system 100. The system 100 determines whether the thickness measured is less than a predetermined value. If the determination is affirmative, the system recognizes that no component is supported by the nozzle or the component is incorrectly supported by the nozzle. Otherwise, at ST 4 (i.e., pickup station), a two-dimensional CCD camera (i.e., displacement detector) picks up a plan image of the component held by the nozzle 132 from its below. Using the image, a horizontal and/or angular displacement of the component is determined, which is then transmitted to the system 100. At ST6, the nozzle rotates about its vertical axis according to the determined, horizontal and/or angular displacement to orient the component in a proper direction.

At ST7 (i.e., mount station), by the use of the result obtained at the image processor, the X-Y table is positioned. Then, the placement head 126 moves down to place the component onto the substrate 18 in position. If it has been determined at ST 3 or ST4 that the component is incorrectly supported on the nozzle or the wrong component is supported on the nozzle, the component is discarded from the nozzle at respective stations. At ST11 (i.e., nozzle select station), the placement head 126 is rotated about its vertical axis depending upon the component to be mounted to place the corresponding nozzle 132 into the outermost position 134.

The angular displacement may be corrected by the rotation of the placement head. This results in a further horizontal displacement of the component, which is eliminated by the movement of the X-Y table.

Next, discussions will be made to an embodiment for mounting the component by the system 100. This method is featured in that a determination is made whether the nozzle or the component supported on the nozzle makes an interference with the component mounted on the substrate, by the use of various criterions.

For this purpose, as shown in block diagram of Fig. 18, the system 100 includes various portions for its controlling. The controller 107 has an NC data store section 141 for storing data defining amounting position of each component on the substrate; an arrangement data store section 142 for storing data of the supply position of each component defined in the NC data and the types of components; a component data store section 143 for storing data defining features such as the shape of each component and the type of each nozzle; a nozzle size data store section 144 for storing data defining the size of each nozzle; a calculator 145 for calculating each distance between two neighboring components on the substrate in both, X and Y directions using data provided from the stores 141, 142, and 143; a distance data store section 146 for storing the calculated distances by the calculator 145; and an interference judge 148 for judging the existence of the interference using data from the data store section 146 and also determining a suitable clearance for each component and mounting position.

In order to mount the components onto the substrate, the system 100 includes NC program, arrangement program, and component library, for example, stored therein. As shown in Fig. 19, the NC program defines an order of components to be mounted and has supply positions (Z-number) and placement positions (X- and Y-coordinates) of the components. As can be seen from the drawing, one line of such data is prepared for each component.

As shown in Fig. 20, the arrangement program 152 defines data that includes the shape of component for each Z-number by the use of associated code in order to distinguish the type of component to be supplied.

As shown in Fig. 21, the component library 153 defines data of component shape code, component feature code, operational condition, supply condition, and neighboring condition. For example, the component shape code defines the type of component. The component feature code defines the size of the component. The supply condition defines how and by what the component is supplied. The neighboring condition defines the size of the nozzle and the clearance between the neighboring components on the substrate in order to determine the interference between the nozzle or component to be mounted and the component mounted.

The interference can be determined using a constant, limit distance defined for the prevention of the interference. However, in this procedure nothing is considered about the neighboring condition of the components. Therefore, according to the present invention, the limit distance is automatically determined by taking the neighboring condition into account for each mounting of component, rather than using the constant, limit distance.

The NC program 151, arrangement program 152, and component library 153 are established and stored prior to the actual mounting of the components. Then, a program for mounting is generated by the combination of the NC program 151 corresponding to the substrate on which the components are mounted and the arrangement program 152 defining the component supply positions and the shapes of the components designated in the NC library 153 with the component shape codes.

Fig. 22 shows a flowchart for calculating a distance between two neighboring components mounted on the substrate and made at a distance calculator 145. In this flowchart, at step Sill NC data store section 141 provides a mounting, horizontal and angular position (x and y coordinates and θ) of the component on the substrate. At step S112, the arrangement data store section 143 provides the shape code of the component. Then, at step S113 the component data store section 143 provides dimensions in the x and y directions of the component corresponding to the shape code. The distance calculator 145 calculates an area ($x_s$, $y_s$) on the substrate to be occupied by the component at step S114. The area ($x_s$, $y_s$) is stored a distance data store section 146.

For example, the area ($x_s$, $y_s$) is defined by the following equations:

$$x_p - \frac{(L\cos R + W\sin R)}{2} \le x_s \le x_p + \left(\frac{L\cos R + W\sin R}{2}\right) \quad (1)$$

$$y_p - \frac{(L\sin R + W\cos R)}{2} \le y_s \le y_p + \left(\frac{L\sin R + W\cos R}{2}\right) \quad (2)$$

wherein, as shown in Fig. 23,

$x_p$, $y_p$: coordinates of center of the component,
R: angle of the component, and
L, W: dimensions of the component.

This calculation is performed for every component to be mounted on the substrate at step S115. Then, the area of one component P is provided from the distance data store section 146. Next, another component leaving a minimum distance from the component in either direction is determined. This process is illustrated in Fig. 24 in which, for one component P, selected in x-direction is the component Pl that leaves a minimum distance Δx from the component P and selected in y-direction is another component Pu that leaves a minimum distance Δy from the component P. For example, as shown in Fig. 24, the x-coordinate ($x_i$) of the center of the selected component Pl and the y-coordinate ($y_u$) of the center of the selected component Pu are defined as follows:

$$x_{l\ min} \le x_{ls} \le x_{l\ max} \quad (3)$$

$$y_{u\ min} \le y_{us} \le y_{u\ max} \quad (4)$$

Then, the minimum distance in the x- and y-directions from the components Pl and Pu, respectively, are determined as follows:Δ

$$\Delta x = x_{p\ min} - x_{l\ max} \quad (5)$$

$$\Delta y = y_{u\ min} - y_{p\ max} \quad (6)$$

wherein $x_{lmin}$ and $x_{lmax}$ are the minimum and maximum x-coordinates of the component Pl, respectively, $y_{umin}$ and $y_{umax}$ are the minimum and maximum y-coordinates of the component Pu, respectively, and $x_{pmin}$ and $y_{pmax}$ are the minimum x-coordinate and the maximum y-coordinate of the component P, respectively. The calculated distance Δx and Δy are stored in the distance data store section 46 at S117.

Referring to Fig. 25, there is shown a flowchart of the procedure for the determination of the possible interference of the component, performed before the mounting of the components 12. In this program, according to the preset mount program, among a number of parts cassettes prepared at the component supply 110 one parts cassette 11 bearing a desired component 3 designated by the mount program is moved to the component supply position 110a. The component 12 is received by the nozzle 132 of the placement head 126 positioned at the component supply section ST1 of the rotary head 110a at step S121.

Then, the rotary head 112 is subject to the index rotation to transport the placement head 126 with the component into the recognition station ST4 where the component is recognized by the two-dimensional CCD camera at step S122. The image recognized by the recognition device is used to determine the relative relationship between the nozzle 132 and the component 12 in the x and y directions at step S123. That is, at this step, it is determined the offsets of the nozzle 132 from the component 12 in the x- and y-directions. Each offset bears a plus or minus sign. Then, the neighboring distance information for the component supported by the nozzle is retrieved from the distance data store section 146 at step S124. Then, another determination is made at step S125 whether the offset of the nozzle 132 from the component, calculated at step S123, is less than the neighboring distance retrieved in either direction. If the offset is greater than the neighboring distance, there exists a possible interference between the nozzle or the component supported on the nozzle and another component mounted on the substrate. Therefore, at step S126 the placement head 126 is moved to the discard station ST6 where the component is released from the nozzle into a collect container not shown. The same component is then picked up again by the nozzle and, if there is no possible interference, mounted on the position of the substrate where the discarded component was intended to be mounted. If, on the other hand, the offset is less than the neighboring distance, the component is mounted at step S127 on a predetermined position of the substrate. If it is determined that the above steps are performed for every component, the program is completed at step S128.

According to the mounting method of this embodiment, data is automatically generated for determining the interference between the nozzle or component supported on the nozzle and another component mounted on the substrate for the nozzle and each component. This eliminates a complicated input process of the respective neighboring distances at the generation of the mounting program. Also, conventional data can also be used in this method without any necessity of modification. This means that no complicated operation is needed for the input of new data for the mounting. Also, the interference is checked for each component independently, which prevents the unwanted discard of the component capable of being mounted. This ensures an effective mounting of the components. Further, immediately after the discard of one component, the same component is mounted on the substrate without moving the rotary head, which ensures to reduce a total time of the mounting.

TENTH EMBODIMENT

Discussions will be made to another system and process for mounting of the component according to the tenth embodiment of the present invention. Generally, in this embodiment, data of the components mounted on the substrate are used for the determination of the interference.

This method is preferably used in the system 100 shown in Figs. 15 to 17. In particular, in addition to the structures shown in Fig. 18, the system 100 further includes a memory section 147 for holding a list of positions of the components mounted on the substrate, which list being dynamically updated after the mounting of each component. A nozzle interference check section 148 determines for each component supported on the nozzle whether it will make an interference with any component mounted on the substrate using data from the memory sections 144, 146 and 147. In each determination, a suitable neighboring limit distance is calculated for each component and its position.

Referring to Fig. 26, there is shown a flowchart indicating procedures carried out at the memory section 147 in Fig. 18 during mounting. For example, when a new substrate is introduced into the system 100, the memory section 147 clears the list of positions of the components mounted in the mountings for the previous substrate at step S131. After a new component is supported on the nozzle at step S132, it is determined at step S133 whether another components neighboring the new component on the substrate has been mounted on the substrate. If the neighboring component has already been mounted on the substrate, the interference check is made only for that neighboring direction according to the procedures described in the ninth embodiment at steps that follow step S134. Otherwise, no interference check is made and the component supported by the nozzle is mounted on the substrate at step S139.

According to the mounting method of this embodiment, if the data shows a possibility of interference between the neighboring components but no interference would occur when considering the actual mounting, the interference check is eliminated. This means that minimum checks are carried out, shortening a time for mounting of each component.

In the previous embodiment, when it is determined that the nozzle or the component supported on the nozzle interferes with the mounted component, the supported component is discarded without being mounted on the substrate and then another component is held by the nozzle for its mounting. In this instance, however, the system may simply be de-energized and then make a warning to an operator of this system. This allows the operator to determine whether the component supported on the nozzle should be discarded.

Although the ninth and tenth embodiments have been described in combination with the system 100 having the rotary head 12, they are equally applied to the system 1 in which the placement head moves back and forth on the substrate fixed in the system shown in Fig. 31 and another system shown in Figs. 27 and 30 in which the placement head has a plurality of nozzles for supporting plural components simultaneously (see Fig. 29). The devices equipped in the system in Fig. 27 are operationally connected to each other as shown in Fig. 28.

The system 200 has a guide portion including a pair of guide rails 252 each extending from a substrate supply section 216 through a substrate support section 217 to a substrate discharge section 218 each located at the center of a base frame 250. This allows that the substrate 18 introduced at the supply section 216 is transported to the support section 217 where the components are mounted thereon and then discharge from the discharge section 218. A base frame 250 arranged above the substrate 18 is provided on its opposite sides with y-axis robots 260 and 262 which in turn support an X-axis robot 264 so that by the driving of the y-axis robots 260 and 262 the x-axis robot moves back and forth in the x-direction. This allows the placement head 266 to be moved horizontally in the x-and y-directions. Each robot has a transport mechanism. For example, the transport mechanism has a nut secured to a movable member and a threaded shaft secured to a fixed member and drivingly connected to a motor so that, by the driving of the motor, the shaft rotates to transport the movable member back and forth alternately.

The placement head 266 supported by the X-Y transport mechanism with the x-axis robot 264 and y-axis robots 260 and 262 supports a component by its nozzle 232 for its placement onto a predetermined position of the substrate. The component may be a circuit chip such as resistor and condenser supplied from a parts cassette, for example, and another large electronic device such as IC connector (e.g., SOP and QFP) supplied from a parts tray, for example. The mounting procedures are controlled by the controller 207 in Fig. 28 according to a program memorized and preset in the memory 1001. The program may be inputted by manually using keys prepared at an operation panel, for example.

The parts cassettes 11 are arranged on opposite sides of the paired guide rails 252, e.g., on the right upper and left lower sides. Each parts cassette 11 has a strip-like component holder wound about a reel and holding a number of components or circuit chips such as resistors and condensers. The parts tray 268, on the other hand, can support a pair of two trays 268a extending perpendicular to the guide rails, respectively. Each tray 268a slides toward the guide rails 252 according to the number of components to be supplied so that the component supply portion stays at a predetermined pickup position with respect to the y-direction. Typically, the tray 268a supports a number of electronic components such as QFP.

A image processor 220 is provided near the substrate positioned by the pair of guide rails 252 in order to detect a two dimensional displacement or the position of the component supported by the nozzle 232 and also to cancel the displacement by the movement of the head 266. The image processor has a recognition device at its bottom and a housing surrounding around the recognition device. A number of light emitters such as light emitting diodes are provided stepwise inside the housing for the illumination of the component supported on the nozzle. This allows that light is emitted from various directions toward a mounting surface of the component, which ensures to pick up a clear image of the component with a suitable angle irrespective of the type of the component. The angle is predetermined for each component according to the preset component recognition data. The image picked up by the image processor 220 is processed by the controller to determine the center of the component and positions of the electrodes to be used for the correction of the placement position and/or angle.

As shown in Fig. 29, the transport head 266 has a component holder or a multiple head with a plurality of placement heads (e.g., first to fourth placement heads 226a to 226d of the same structure). Each placement head has a nozzle 232, an actuator 278 for moving the nozzle 272 up and down, and a pulley 284. The pulleys 284 of the first and third placement heads 226a and 226c are drivingly connected through a timing belt 282 to a θ-rotation motor 280a so that the nozzles 232 of the heads can rotate about respective vertical axes thereof simultaneously. The pulleys 284 of the second and fourth placement heads 226b and 226d are connected through another timing belt 282 to another θ-rotation motor 280b so that the nozzles 232 of the heads can rotate about respective axes thereof simultaneously. Each actuator 278 is made of air-cylinder, for example, so that by turning on and off the air-cylinder the nozzle head 232 moves up and down for receiving and holding of the component. Although as shown in Fig. 29 the rotation of the motor 280a is transmitted through the timing belt to rotate the nozzles 232 of the placement heads 226a and 226c and the rotation of the motor 280b is transmitted through another timing belt to rotate the nozzles 232 of the placement heads 226b and 226d, each of the placement heads 226a-226d is connected to an individual motor for its θ-rotation. However, in order to reduce the weight of the unit of the placement heads, the number of motors is minimized.

Each nozzle 232 of the placement head is replaceable and spare nozzles are accommodated in a nozzle stacker 286 mounted on the substrate 250 of the system 200. Generally, a various nozzles are used such as small size nozzle for the chips of about 1.0mm x 0.5mm and medium size nozzle for QFP of about 18mm x 18mm.

In operation, the substrate 18 is introduced at the supply section 216 of the paired guide rails 252 and then transported into the holding section 217. Then, the placement head 266 is moved by the X-Y robot transversely or horizontally in the X-Y plane to receive the predetermined component from the parts cassette 11 or parts tray 268. The component is then passed by the recognition device of the image processor 220 to recognize the position of the component supported by the nozzle. Using the position of the component, the motor drives to rotate the nozzle 232 for the correction of the position of the component, if necessary. Then, the component is placed on the predetermined component mounting position on the substrate 18.

Each of the placement heads 226a-226d moves down the nozzle 232 vertically, i.e., in the z-direction, by the driving of the actuator 278 when catching the component from the parts cassette 11 or the parts tray 268 and also when placing the component onto the substrate 18. Also, the nozzle is replaced depending upon the type of the component.

By the repetition of the catching and mounting, all of the components are mounted on the substrate. The substrate onto which every component has been mounted is transported from the holding section 217 to the discharge section 218. Then, a new substrate is introduced from the supply section 216 into the holding section 217 where the components are mounted on the substrate.

An inertial force generated at the acceleration and deceleration of the component and an adhering force between the component and the substrate should be considered when deciding a vacuum force applied from the nozzle to the component. Therefore, the components are divided into several groups, i.e., high speed, medium speed, and low speed mounting components depending upon the weight and size thereof.

Also, a plurality of placement heads may be used for the simultaneous catching and/or mounting of the components.

In operation of the system 200, each distance of the neighboring components is calculated according to the program shown in Fig. 22 and then stored in the memory unit 146. As shown in Fig. 30, the substrate 18 is transported from the supply section 216 into the holding section 217. On the other hand, the component is picked up from the parts cassette or pats tray 268 by the placement head 216 driven according to the mounting program. Next, similar to the ninth and tenth embodiments, the interference is checked for the component supported on the nozzle according to the flowchart shown in Fig. 25. For this purpose, while the placement head moves above the image processor 220, the recognition device takes a picture of the component supported on the nozzle. Using the image picked up by the recognition device, the position or the displacement of the component relative to the nozzle is determined. Then, it is determined whether the displacement of the component relative to the nozzle is less than the neighboring distance derived from the data unit 146. If the placement is greater than the neighboring distance, the component is discarded. Otherwise, the component is mounted on the substrate. The interference check between the nozzle or component supported on the nozzle and the component mounted on the substrate is performed as described in the second embodiment.

ELEVENTH EMBODIMENT

Discussions will be made to the eleventh embodiment of the present invention. This embodiment is directed to a computer readable recording medium. In this medium, a program having procedures for judging the interference between the nozzle 13, 132, and 232 and the mounted component 12a is recorded therein. For example, the program has several steps of

catching the component from the component supply by the component holder;
recognizing the component supported by the component holder;
using a result of the component recognition and determining whether the component is supported properly by the component holder;
when it is determined that the component is supported by the component holder so that the component will not be mounted properly, discarding the component to a collect station;
when on the other hand it is determined that the component is supported by the component holder so that the component will be mounted properly, determining whether a height of the component is greater than that of the component mounted on a substrate;
when it is determined that the height of the component is less than that of the mounted component, determining whether the component holder makes an interference with the mounted component at the mounting of the component supported on the component holder;
when it is determined that the component holder makes the interference with the component mounted on the substrate, discarding the component supported by the component holder into the collect section without mounting the component supported by the component holder;
when it is determined that the component holder does not make the interference with the component mounted on the substrate, determining whether a height of the component supported by the component holder is greater than that of the neighboring component mounted on the substrate; and
when it is determined that the height of the component supported by the component holder is greater than that of the component mounted on the substrate, calculating an adjustment for correcting the horizontal and/or angular displacement of the component relative to the component holder.

The process has been described in detail in connection with another embodiment and, therefore, no further discussion will be made thereto.

The recording medium is preferably used for the system described in connection with the second embodiment, for example. Also, the program recorded in the recording medium is installed and then carried out in the controller 7, 107, or 207.

Although in the process recorded in the medium the component supported by the component holder is discarded if it is determined that the component makes the interference with another component mounted on the substrate, the horizontal and/or angular position of the nozzle and/or the component may be adjusted so as not to interfere with the component mounted on the substrate for the mounting of the component rather discarding the component as described in connection with the sixth embodiment. Likewise, processes described in connection with other embodiments can also be memorized in respective recording mediums. In this case, each of the recording mediums is used for the installation of the program into the controller 7, 107, or 207.

In conclusion, the present invention prevents the interference between the component holder or the component supported by the component holder and another component mounted on the substrate even though there remains a slight clearance between the components, producing a high quality substrate on which components have been mounted.

## Claims

**1.** A method for mounting components in which a holder receives a component from a component supply and then places the component on a substrate, comprising the steps of:

making a judgement whether the holder makes an interference with another component mounted on the substrate;
if the judgement is affirmative, prohibiting an mounting of the component held by the holder; and
if the judgement is negative, mounting the component held by the holder on the substrate.

**2.** A method for mounting components, comprising the steps of:

causing a holder to receive a component from a component supply;
recognizing a position of the component held by the holder;
using the recognized position of the component to correct a horizontal and/or angular displacement of the component relative to the holder, if necessary; and
mounting the component of which position has been corrected, if necessary;
before mounting, making a judgement whether the holder makes an interference with another component mounted on the substrate;
if the judgement is affirmative, prohibiting an mounting of the component held by the holder; and
if the judgement is negative, mounting the component held by the holder on the substrate.

**3.** A method in accordance with claim 1, wherein the judgement further including the steps of:

making another judgement whether a height of the component held by the holder is greater than that of the component mounted on the substrate; and
if the another judgement is affirmative, determining that the holder makes no interference with the component mounted on the substrate.

**4.** A method in accordance with claim 2, wherein the judgement further including the steps of:

defining a reference area for the component mounted on the substrate;
assuming that a displacement of the component relative to the holder is corrected;
making a judgement whether at least a part of the holder supporting the component of which displacement has been assumed to be corrected falls outside the reference area,
if the judgement is affirmative, determining that the holder makes the interference with the component mounted on the substrate.

**5.** A method for mounting components in which a holder receives a component from a component supply and then places the component on a substrate, comprising the steps of:

repeating a plurality of mountings of the components;
obtaining a tendency of interference of neighboring components on the substrate from the plurality of mountings; and
making a correction to reduce the tendency in the subsequent mountings of the components.

**6.** An apparatus for mounting components on a substrate, comprising:

a component supply for supplying components to be mounted on the substrate;
a holder for receiving the component from the component supply and then mounting the component on the substrate; and
a controller for controlling a movement of the holder;

wherein the controller judges before mounting of the component whether the holder interferes with the component mounted on the substrate and, if affirmative, prohibits the component held by the holder form being mounted on the substrate but, if negative, allows the component held by the holder to be mounted on the substrate.

**7.** An apparatus for mounting components on a substrate, comprising:

a component supply for supplying components to be mounted on the substrate;
a holder for receiving the component from the component supply and then mounting the component on the substrate;
a image processor for recognizing a position of the component held by the holder relative to the holder;
a controller for correcting the position of the component relative to the holder and then causes the holder to place the component on the substrate;

wherein the controller makes a judgement before mounting of the component whether the holder interferes with the component mounted on the substrate and, if affirmative, prohibits the component held by the holder form being mounted on the substrate but, if negative, corrects the position of the component relative to the holder and then allows the component held by the holder to be mounted on the substrate.

**8.** An apparatus in accordance with claim 7, wherein the controller determines in the interference judgement whether a height of the component held by the holder is greater than that of the component mounted on the substrate and, if affirmative, the controller determines that the holder does not interfere with the component mounted on the substrate.

**9.** An apparatus in accordance with claim 7, wherein the controller defines a reference area for the component mounted on the substrate, assumes that a displacement of the component relative to the holder is corrected, makes a judgement whether at least a part of the holder supporting the component of which displacement has been assumed to be corrected falls outside the reference area, and if affirmative, determines that the holder makes the interference with the component mounted on the substrate.

**10.** An apparatus in accordance with claim 7, wherein the controller defines a reference area for the component mounted on the substrate, assumes that a displacement of the component relative to the holder is corrected, makes a judgement whether at least a part of the holder supporting the component of which displacement has been assumed to be corrected overlaps the component mounted on the substrate, and if affirmative, determines that the holder makes the interference with the component mounted on the substrate.

**11.** An apparatus in accordance with claim 7, wherein the controller defines a reference area for the component mounted on the substrate, the reference area being expanded from an outline of the component, assumes that a displacement of the component relative to the holder is corrected, makes a judgement whether at least a part of the holder supporting the component of which displacement has been assumed to be corrected interferes with the component mounted on the substrate, and if affirmative, determines that the holder makes the interference with the component mounted on the substrate.

**12.** An apparatus in accordance with claim 6, wherein if it is determined that the holder interferes with the component mounted on the substrate, the controller corrects a position of the holder relative to the substrate, makes another judgement whether the corrected holder interferes with the component mounted on the substrate and, if affirmative, prevents the component from being mounted on the substrate but, if negative, allows the component to be mounted on the substrate.

**13.** An apparatus in accordance with claim 6, further comprising

another image processor for a recognition of the component mounted on the substrate;

wherein the controller acquires the recognition of the component around which the component held by the holder is to be mounted and then determines whether the holder interferes with the component mounted on the substrate.

**14.** A method for mounting components in which a holder receives a component from a component supply and then places the component on a substrate, comprising the steps of:

using an individual criterion associated to the. component held by the holder to determine whether the holder or the component held by the holder interferes with the each component mounted on the substrate.

**15.** A method for mounting components in which a holder receives a component from a component supply and then places the component on a substrate, comprising the steps of:

using an individual criterion associated to a position of the component held by the holder to determine whether the holder or the component held by the holder interferes with the each component mounted on the substrate.

**16.** A method in accordance with claim 14, further comprising the steps of:

determining, for each of the components to be mounted, a region of the substrate on which the component is placed;
calculating, for each of the determined regions, a distance from another region adjacent the each of determined regions;
determining a displacement of the component relative to the holder holding the component;
determining whether the displacement is less than the distance determined for the component; and
if affirmative, mounting the component on the substrate.

**17.** A method in accordance with claim 14, further comprising the step of:

before mounting the component, determining whether another component supposed to neighbor the component on the substrate has already been mounted on the substrate; and
if negative, the component is permitted to be mounted on the substrate irrespective of its displacement.

**18.** A method in accordance with claim 16, further comprising the step of: further comprising the steps of:

if the displacement is greater than the distance, discarding the component held by the holder; and
then holding another component by the holder for an mounting of the another component, the another component having the same size with the discarded component.

**19.** An apparatus in which a holder receives a component from a component supply and then places the component on a substrate, comprising:

a calculator that determines, for each of the components, an area of the substrate on which the component is mounted and a distance from a neighboring component on the substrate;
a detector that takes an image of the component held by the holder and determines a displacement of the component relative to the holder; and
a controller that, if the displacement is less than the distance associated thereto, mounts the component held by the holder on the substrate but, if the displacement is greater than the distance associated thereto, prohibit the component from being mounted on the substrate.

**20.** An apparatus in accordance with claim 19, further comprising:

a memory section that includes a list of components mounted on the substrate, the list being updated after the component has been mounted on the substrate;

wherein, if another component neighboring to the area of the component held by the holder has not been listed on the list, the controller allows the component held by the holder to mount on the substrate irrespective of the displacement thereof.

**21.** A computer readable recording medium including a program which is installed in an apparatus for mounting components on a substrate, wherein the apparatus has a component supply for supplying components, a holder for receiving the component from the component supply and then mounting the component on the substrate, and a controller for controlling an operation for mounting the component on the substrate, comprising

an instruction that determines whether the holder holding the component interferes with another component mounted on the substrate;
an instruction that, if it is determined the holder interferes with another component mounted on the substrate, prevents the holder from mounting the component held by the holder; and
an instruction that, if it is determined the holder does not interfere with another component mounted on the substrate, allowing the holder to mount the component held by the holder.

Fig.1

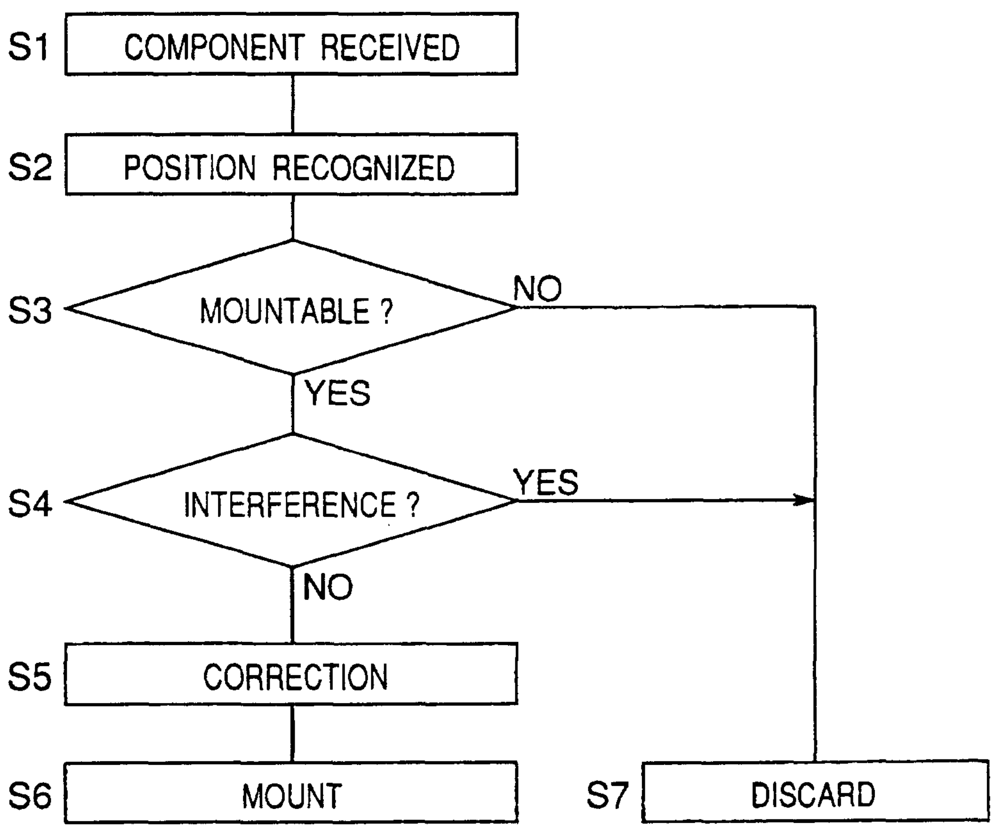
S1
COMPONENT RECEIVED
S2
POSITION RECOGNIZED
S3
MOUNTABLE ?
NO
YES
S4
INTERFERENCE ?
YES
NO
S5
CORRECTION
S6
MOUNT
S7
DISCARD

Fig.2

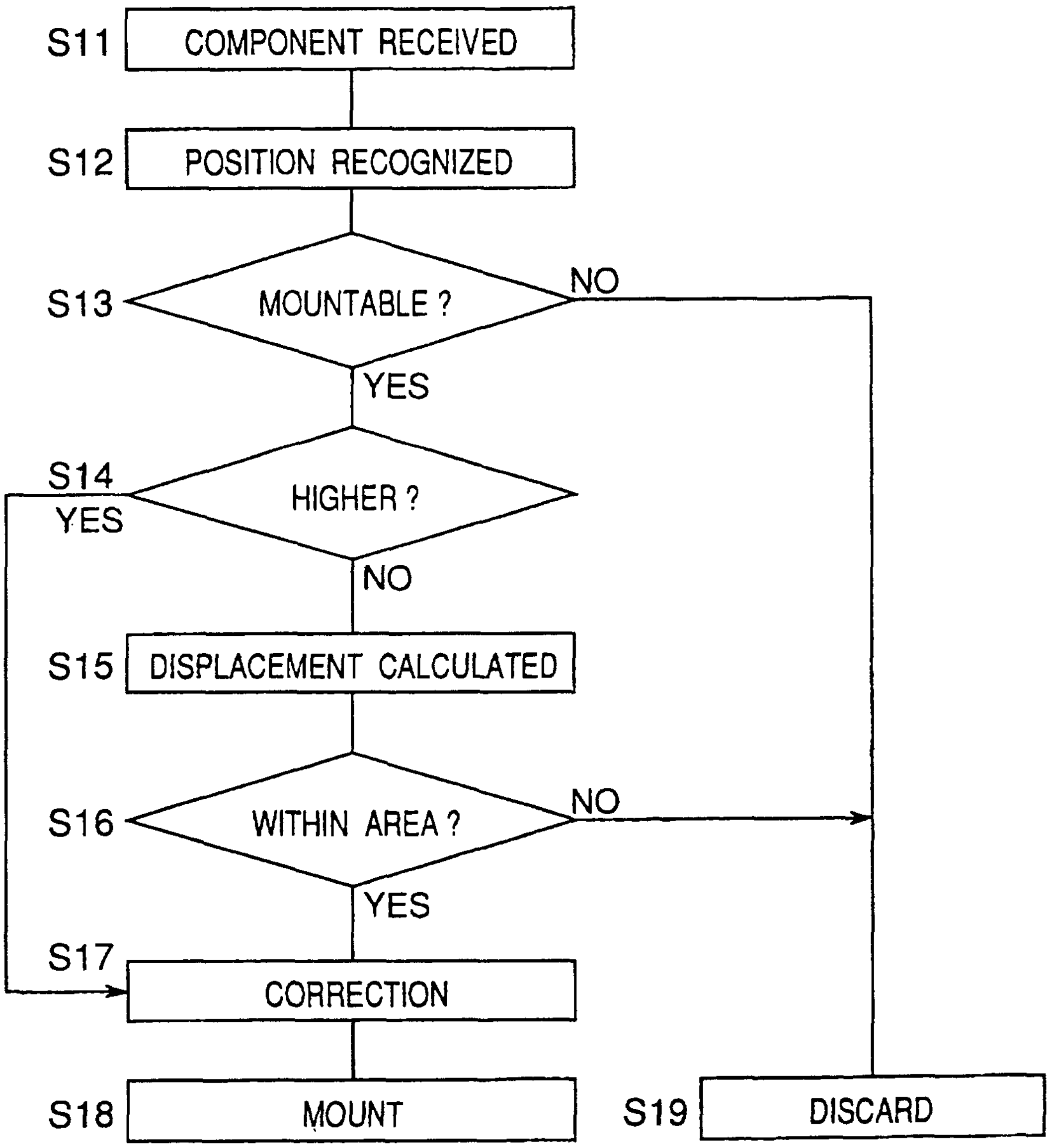
S11
COMPONENT RECEIVED
S12
POSITION RECOGNIZED
S13
MOUNTABLE ?
NO
YES
S14
HIGHER ?
YES
NO
S15
DISPLACEMENT CALCULATED
S16
WITHIN AREA ?
NO
YES
S17
CORRECTION
S18
MOUNT
S19
DISCARD

Fig.3

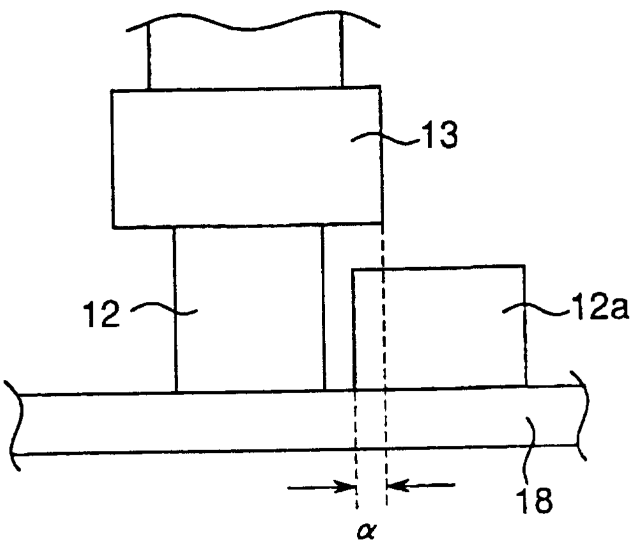


Fig.4A

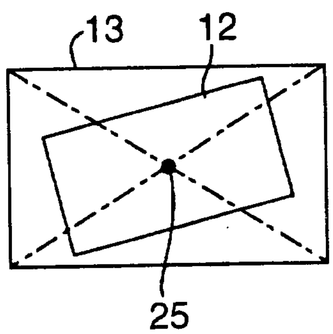


Fig.4B

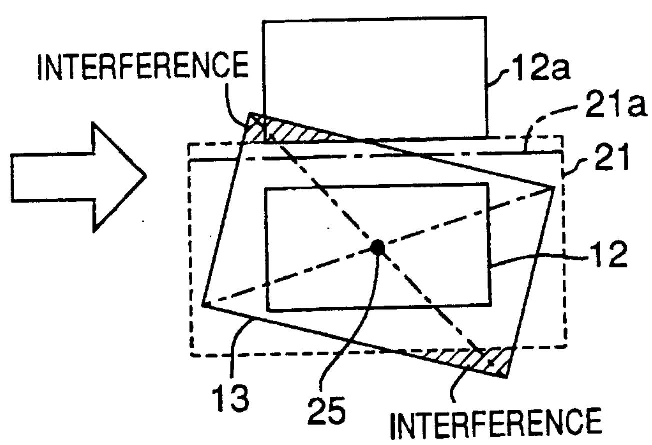

*Fig.5*

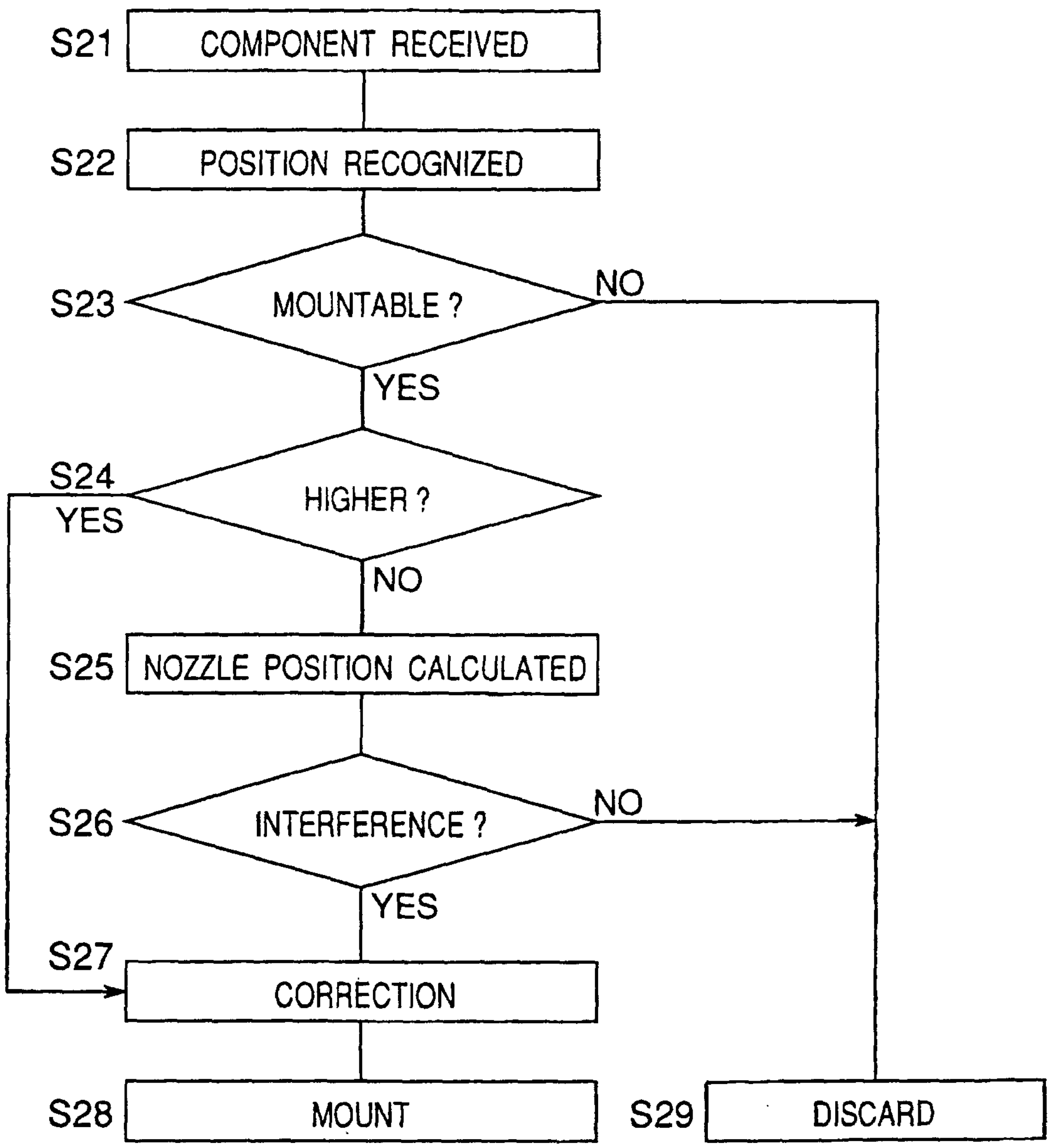
S21
COMPONENT RECEIVED
S22
POSITION RECOGNIZED
S23
MOUNTABLE ?
NO
YES
S24
HIGHER ?
YES
NO
S25
NOZZLE POSITION CALCULATED
S26
INTERFERENCE ?
NO
YES
S27
CORRECTION
S28
MOUNT
S29
DISCARD

Fig.6A

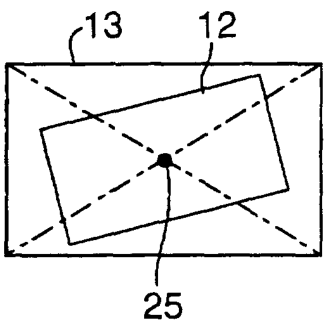


Fig.6B

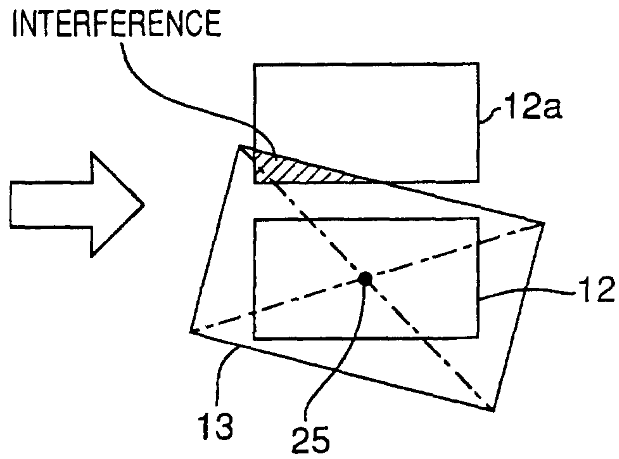

Fig.7

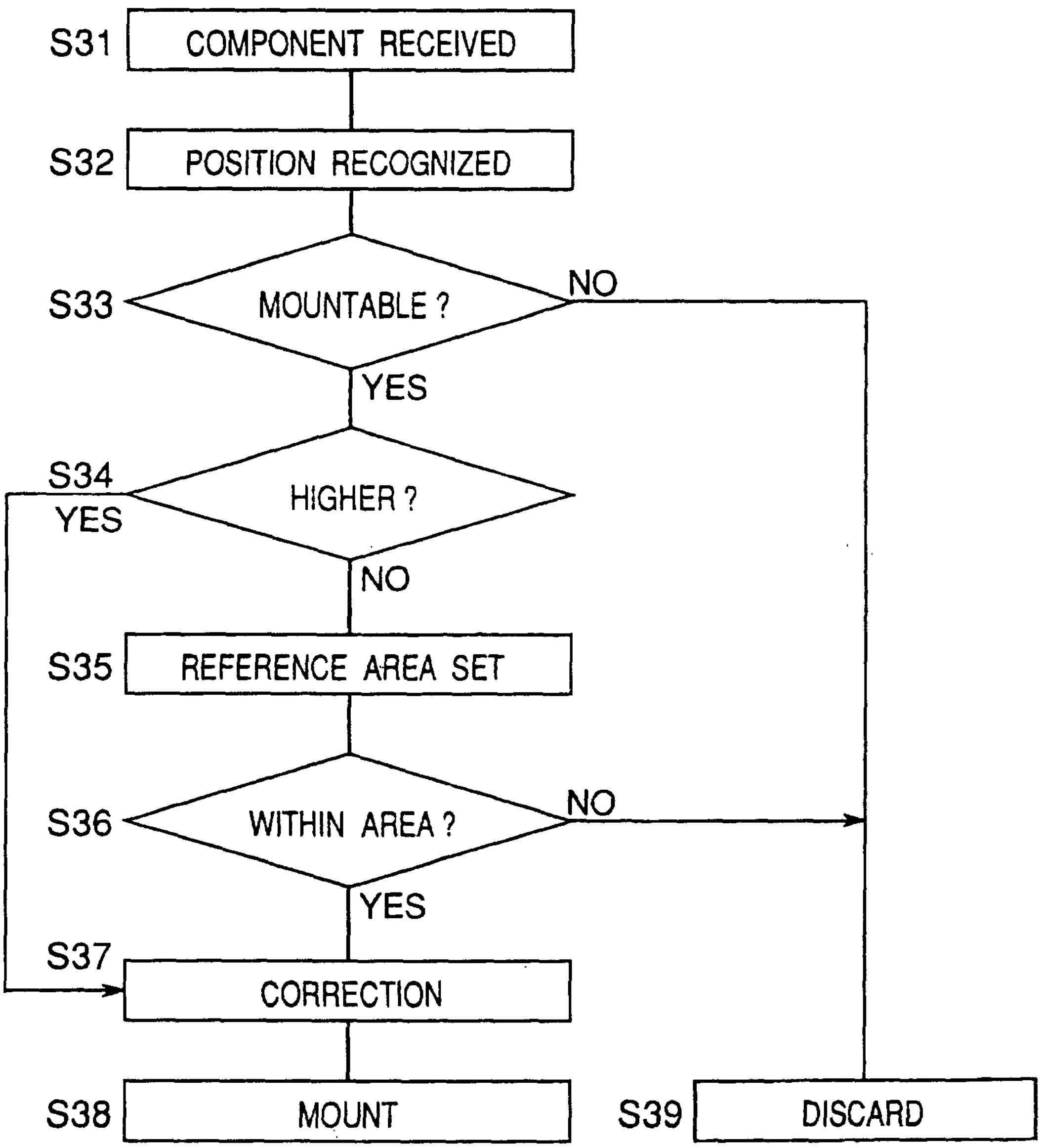
S31
COMPONENT RECEIVED
S32
POSITION RECOGNIZED
S33
MOUNTABLE ?
NO
YES
S34
HIGHER ?
YES
NO
S35
REFERENCE AREA SET
S36
WITHIN AREA ?
NO
YES
S37
CORRECTION
S38
MOUNT
S39
DISCARD

Fig.8A

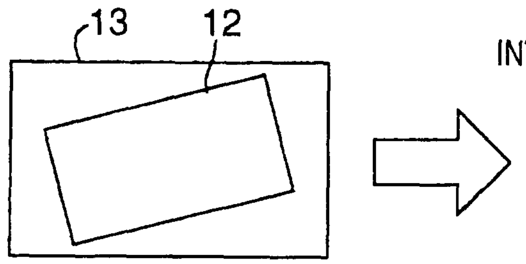


Fig.8B

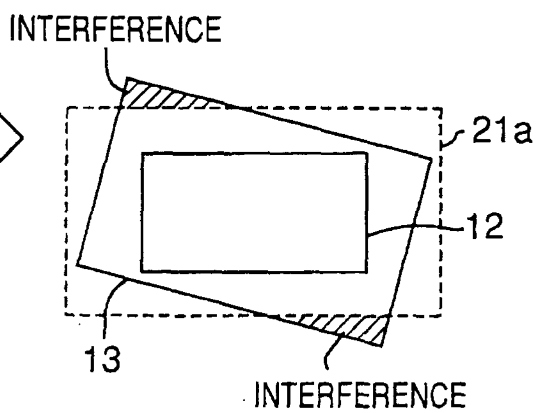


Fig.8C

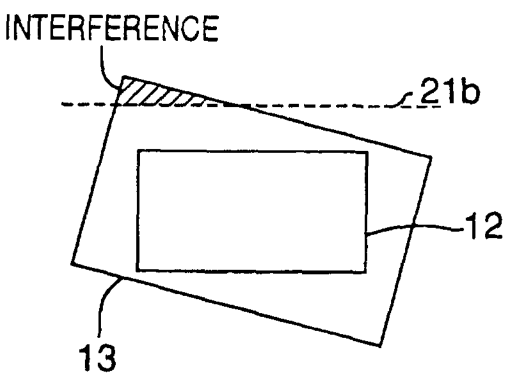

Fig.9A

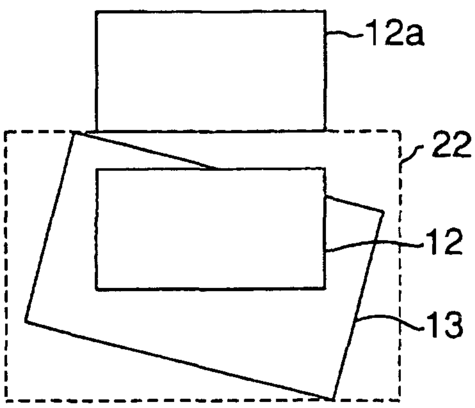


Fig.9B

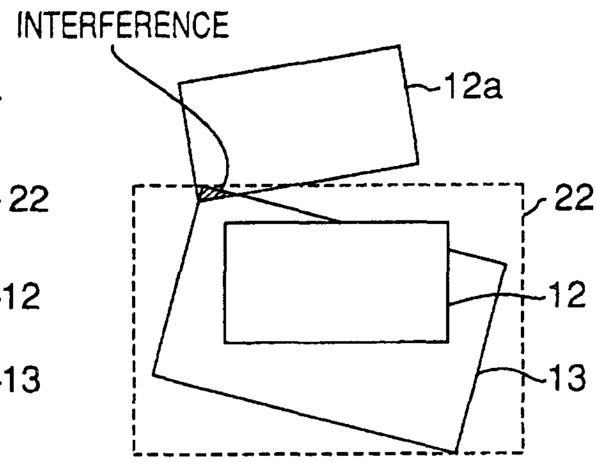


Fig.9C

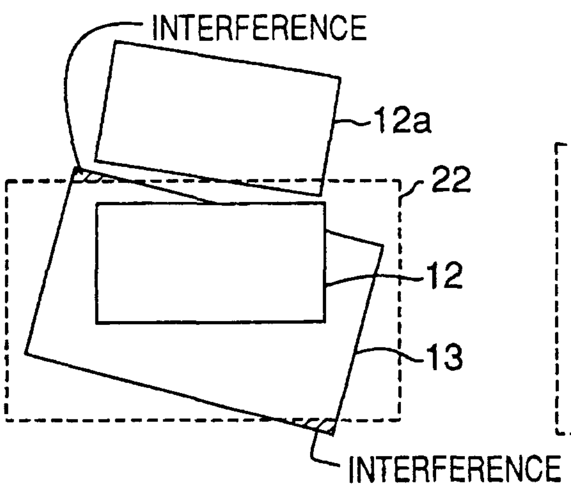


Fig.9D

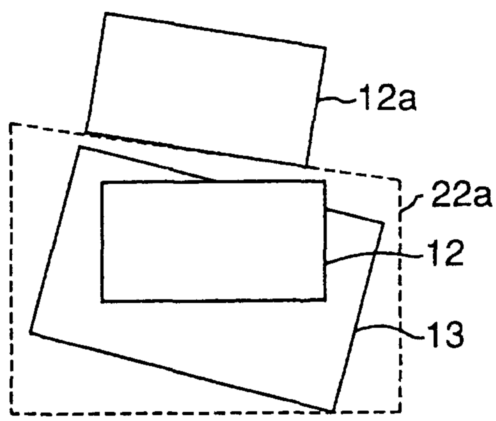

Fig.10

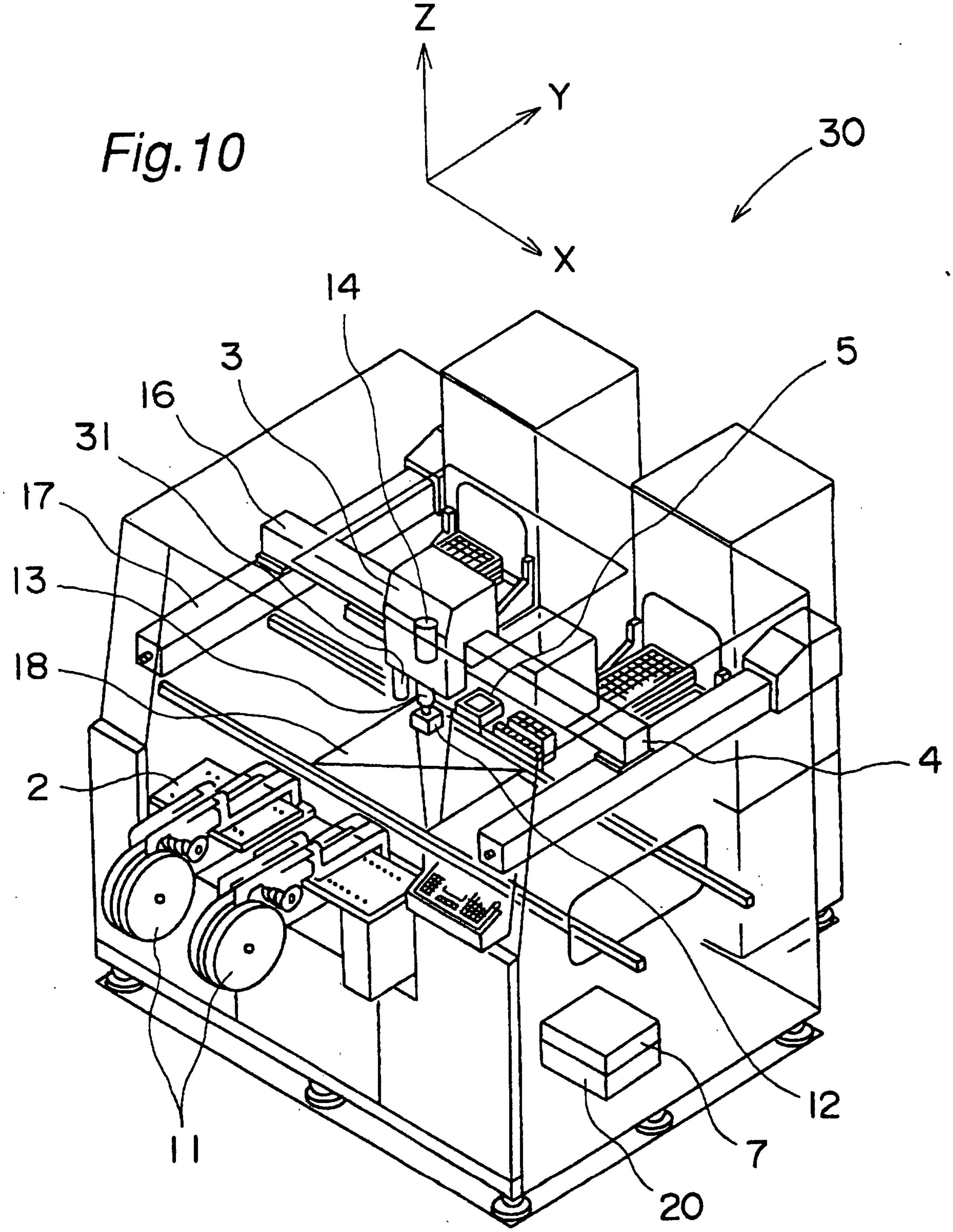

*Fig.11*

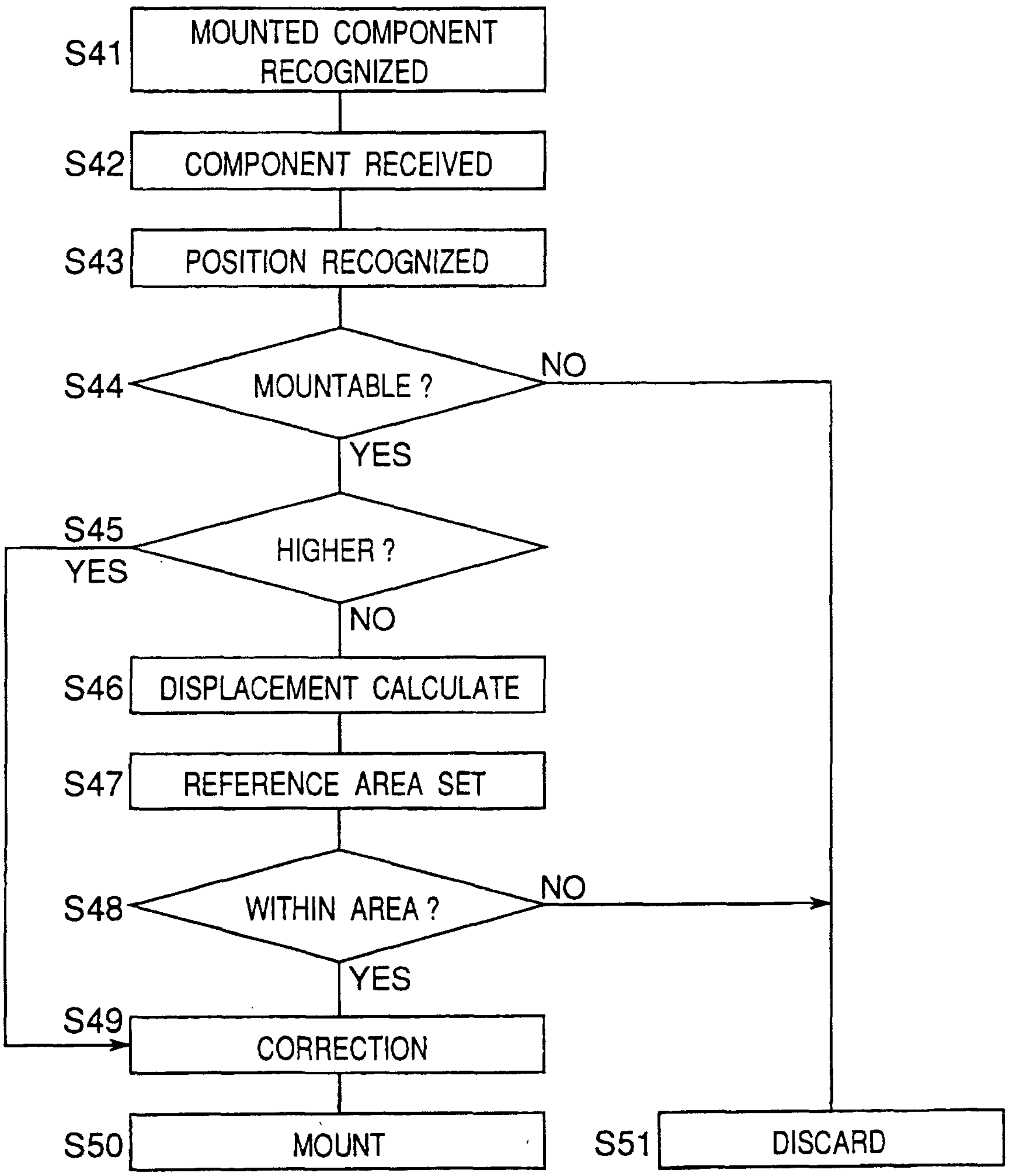
S41
MOUNTED COMPONENT RECOGNIZED
S42
COMPONENT RECEIVED
S43
POSITION RECOGNIZED
S44
MOUNTABLE ?
NO
YES
S45
HIGHER ?
YES
NO
S46
DISPLACEMENT CALCULATE
S47
REFERENCE AREA SET
S48
WITHIN AREA ?
NO
YES
S49
CORRECTION
S50
MOUNT
S51
DISCARD

Fig.12A

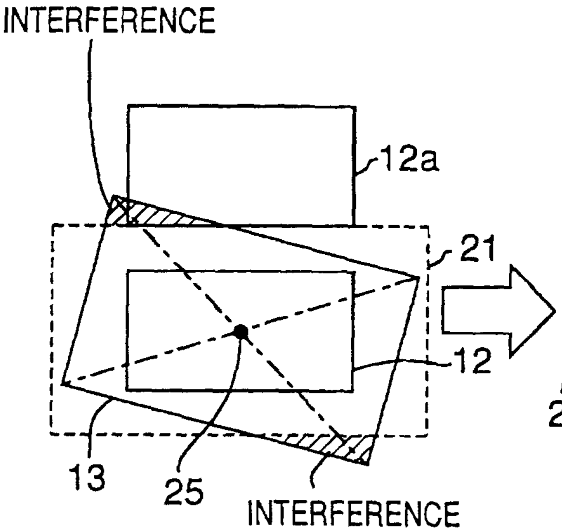


Fig.12B

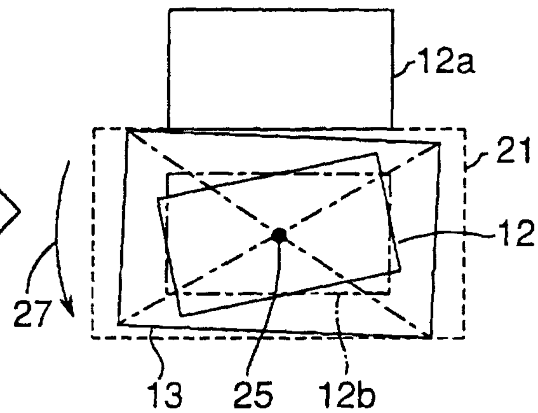

Fig.13

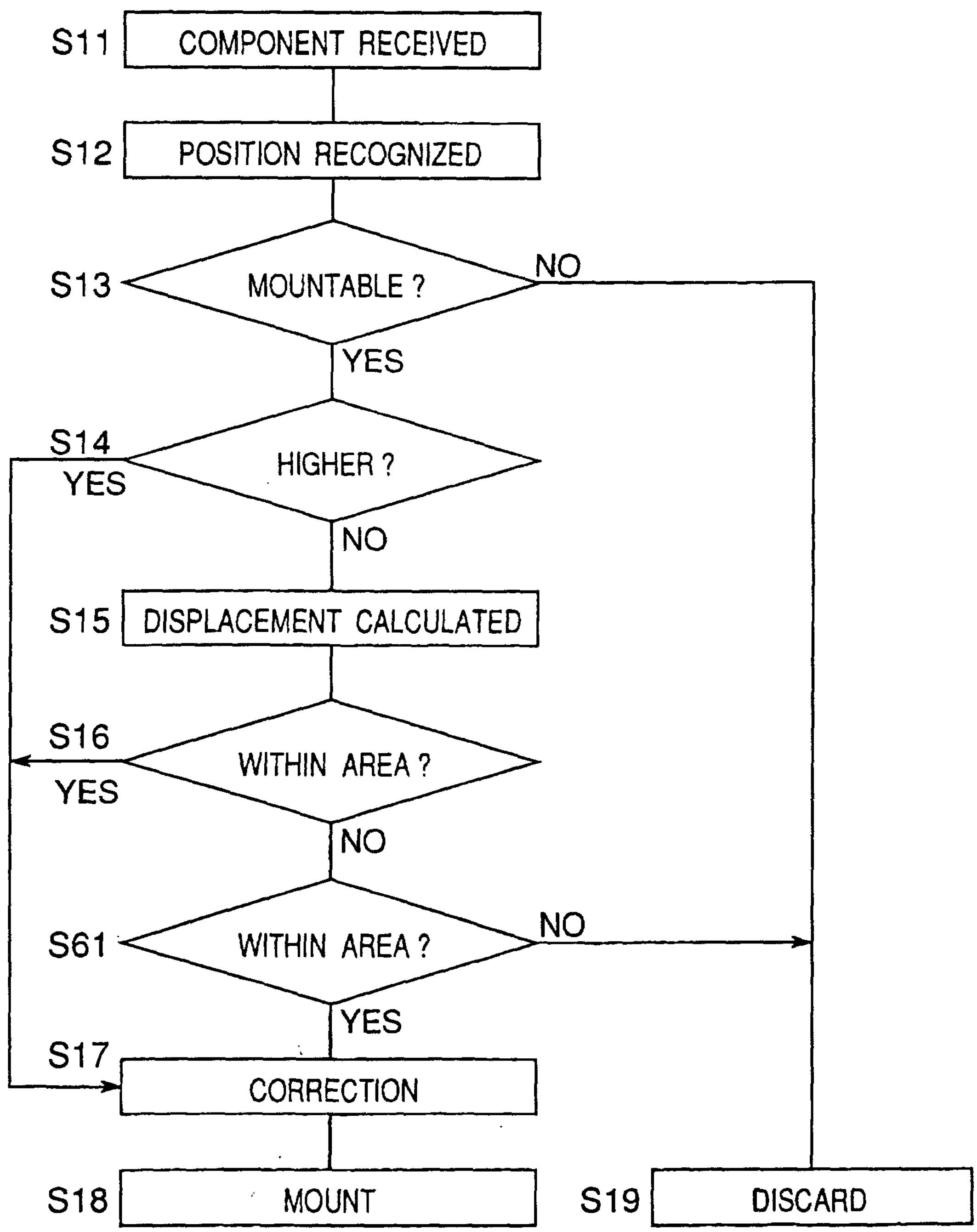
S11
COMPONENT RECEIVED
S12
POSITION RECOGNIZED
S13
MOUNTABLE ?
NO
YES
S14
HIGHER ?
YES
NO
S15
DISPLACEMENT CALCULATED
S16
WITHIN AREA ?
YES
NO
S61
WITHIN AREA ?
NO
YES
S17
CORRECTION
S18
MOUNT
S19
DISCARD

*Fig.14*

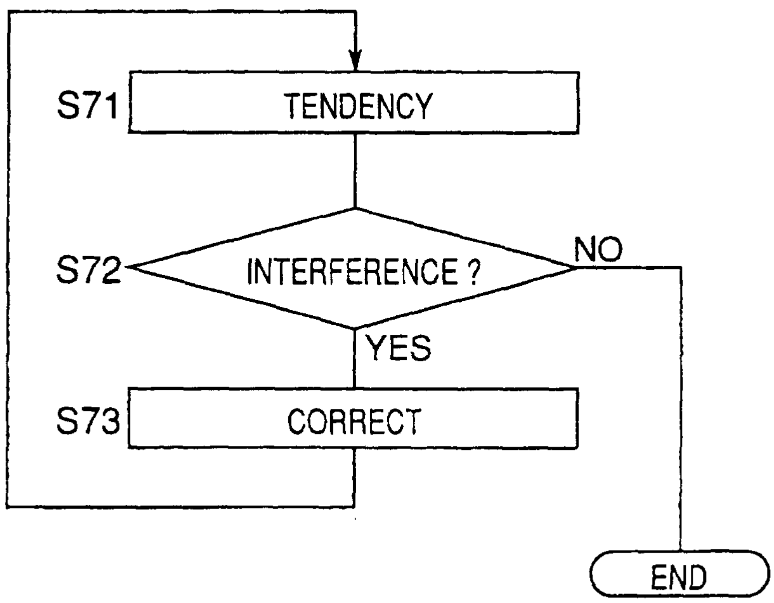

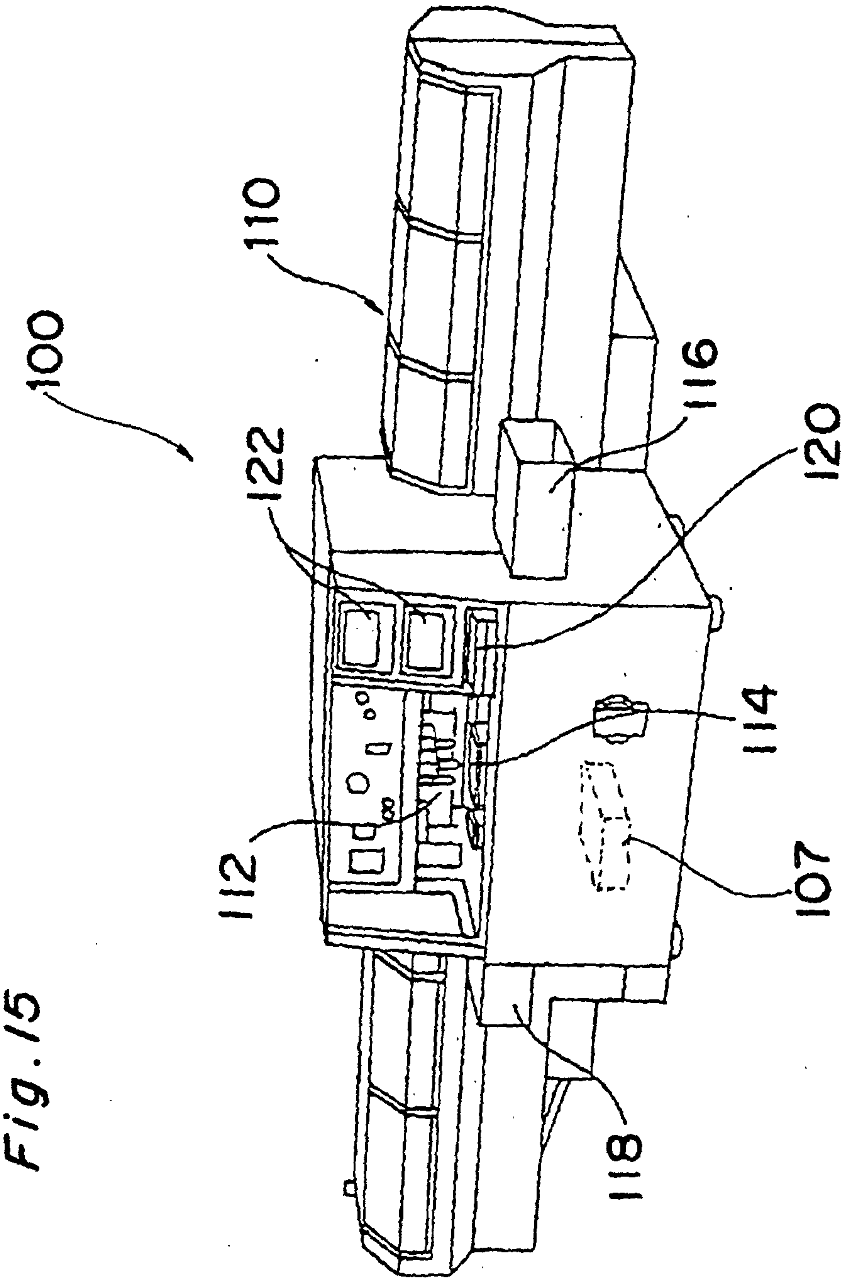


Fig. 15

Fig. 16

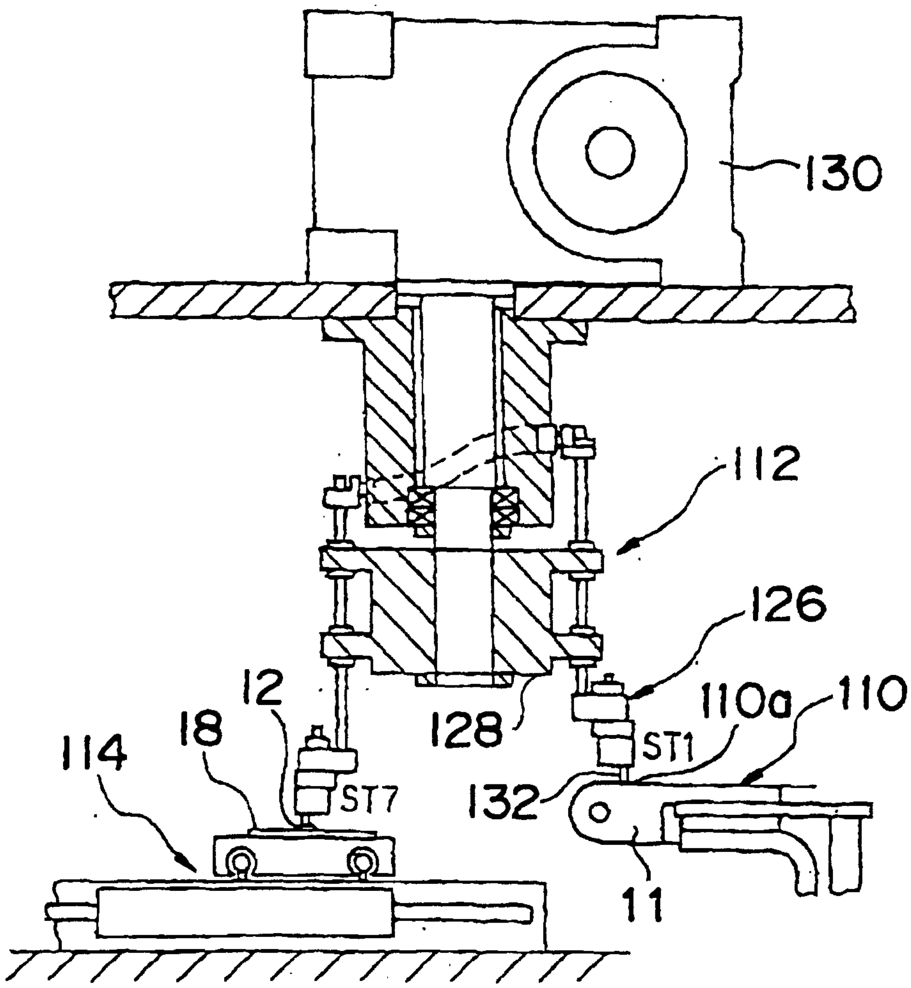

Fig. 17

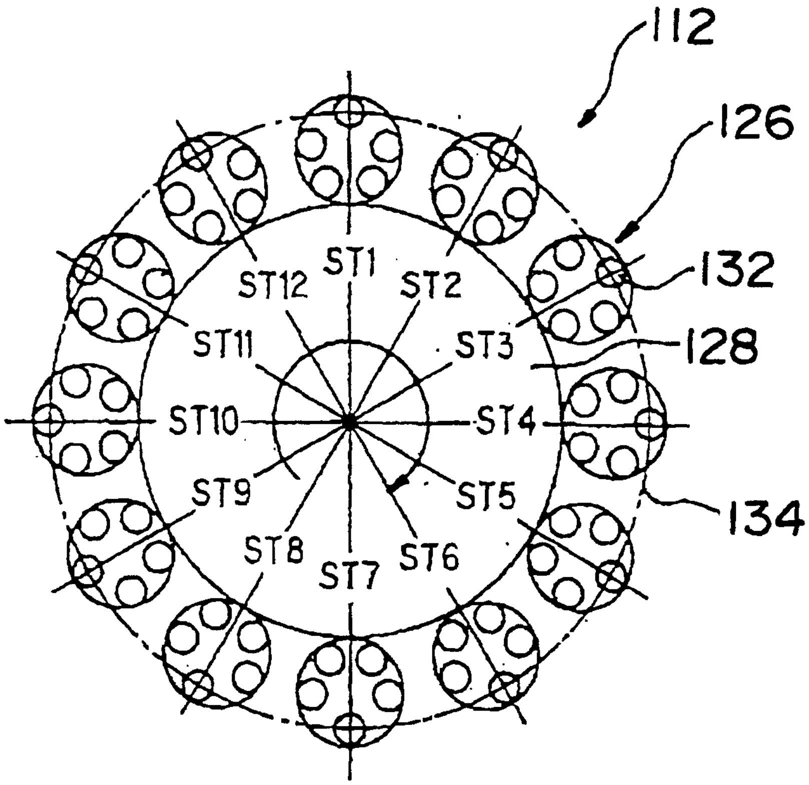
112
126
132
128
134
ST1
ST2
ST3
ST4
ST5
ST6
ST7
ST8
ST9
ST10
ST11
ST12

*Fig.18*

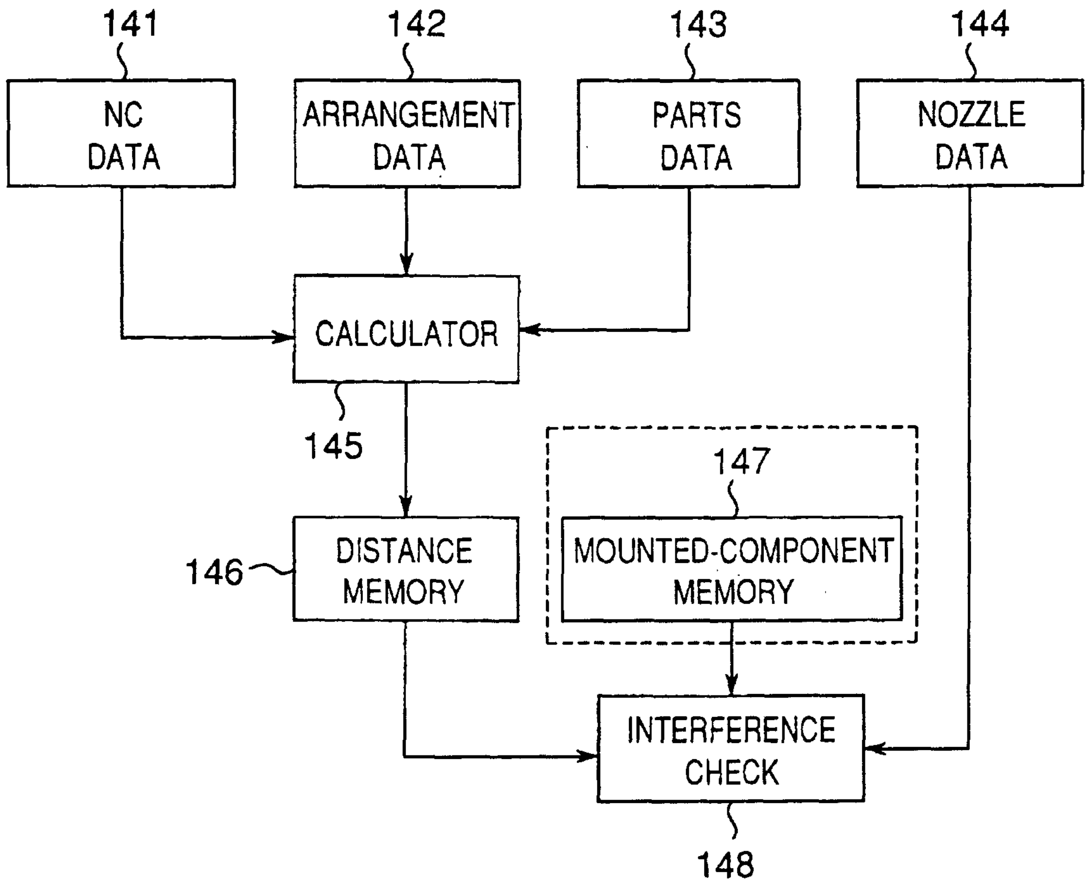
141
142
143
144
NC DATA
ARRANGEMENT DATA
PARTS DATA
NOZZLE DATA
CALCULATOR
145
147
146
DISTANCE MEMORY
MOUNTED-COMPONENT MEMORY
INTERFERENCE CHECK
148

*Fig.19*

151

| BLOCK | X | Y | Z | · · · |
|---|---|---|---|---|
| 1 | 0.00 | 0.00 | 1 | |
| 2 | -5.00 | 0.00 | 1 | |
| 3 | -10.00 | 0.00 | 2 | |
| 4 | -10.00 | -10.00 | 3 | |
| 5 | -10.00 | -15.00 | 4 | |
| ⋮ | | | | |

*Fig.20*

152

| Z | COMPONENT CODE | · · · |
|---|---|---|
| 1 | 1608R | |
| 2 | 2125C | |
| 3 | 1608R | |
| 4 | 1608R | |
| 5 | AL−3P | |
| ⋮ | | |

*Fig.21*

153

| SHAPE | FEATCENE | | OPERATION | | SUPPLY | | NEIGHBOR | |
|---|---|---|---|---|---|---|---|---|
| | | ··· | HEAD SPEED | ··· | SUPPLY METHOD | ··· | NOZZLE SHAPE | LIMIT |
| 0608R | 1.6×0.8 | | 1 | | PAPER 6mm | | 1.8×1.0 | 0.2mm |
| 2125C | 2.0×1.25 | | 1 | | PAPER 6mm | | 2.0×1.8 | 0.3mm |
| AL−3P | 3.2×2.0 | | 3 | | EMBOSS 8mm | | 3.0×2.0 | 0.0mm |
| | | | | | | | | |

*Fig.22*

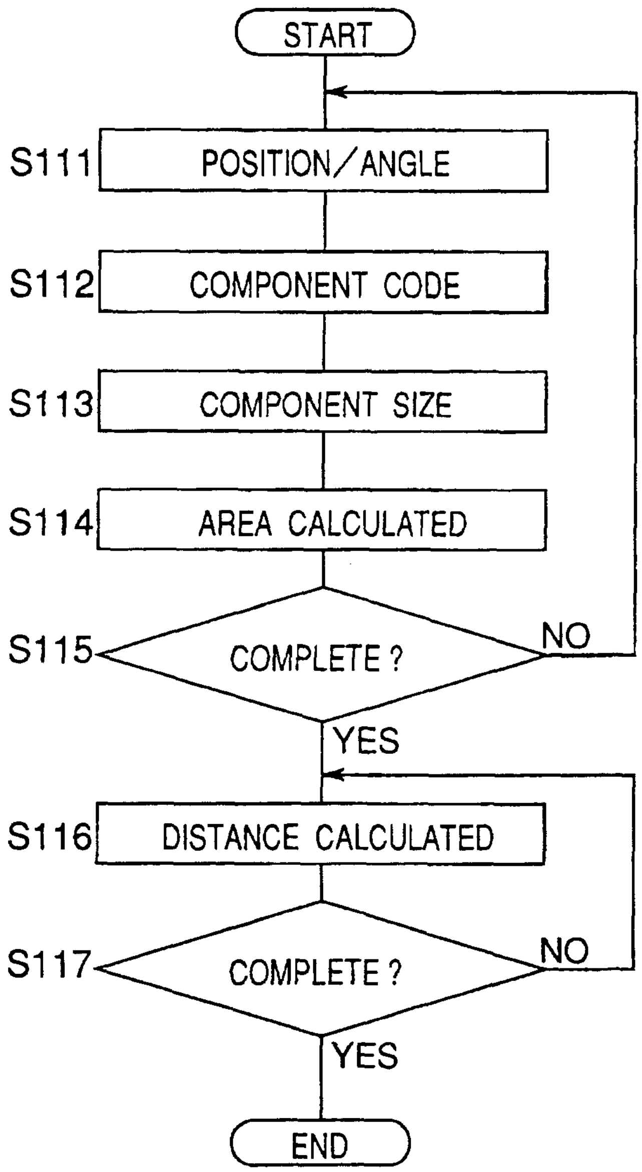
START
S111
POSITION/ANGLE
S112
COMPONENT CODE
S113
COMPONENT SIZE
S114
AREA CALCULATED
S115
COMPLETE ?
NO
YES
S116
DISTANCE CALCULATED
S117
COMPLETE ?
NO
YES
END

Fig. 23

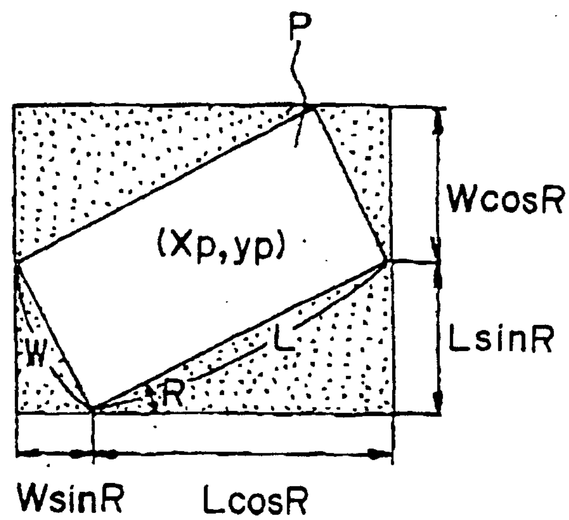
P
WcosR
(Xp, yp)
LsinR
W
L
R
WsinR
LcosR

Fig. 24

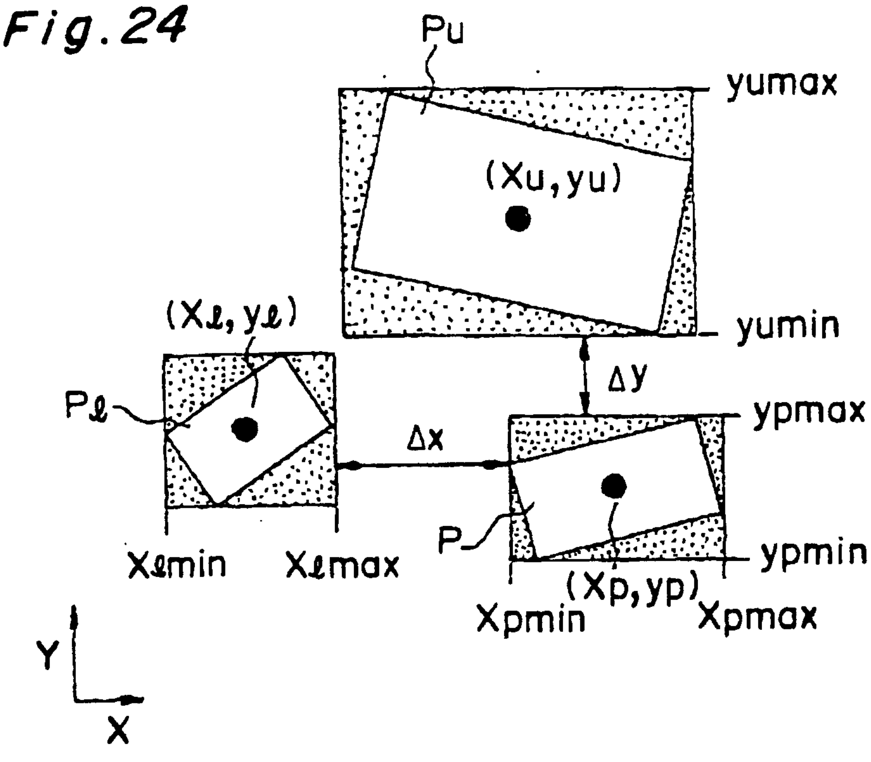
Pu
yumax
(Xu, yu)
yumin
(Xℓ, yℓ)
Pℓ
Δy
ypmax
Δx
P
ypmin
Xℓmin
Xℓmax
(Xp, yp)
Xpmin
Xpmax
Y
X

*Fig.25*

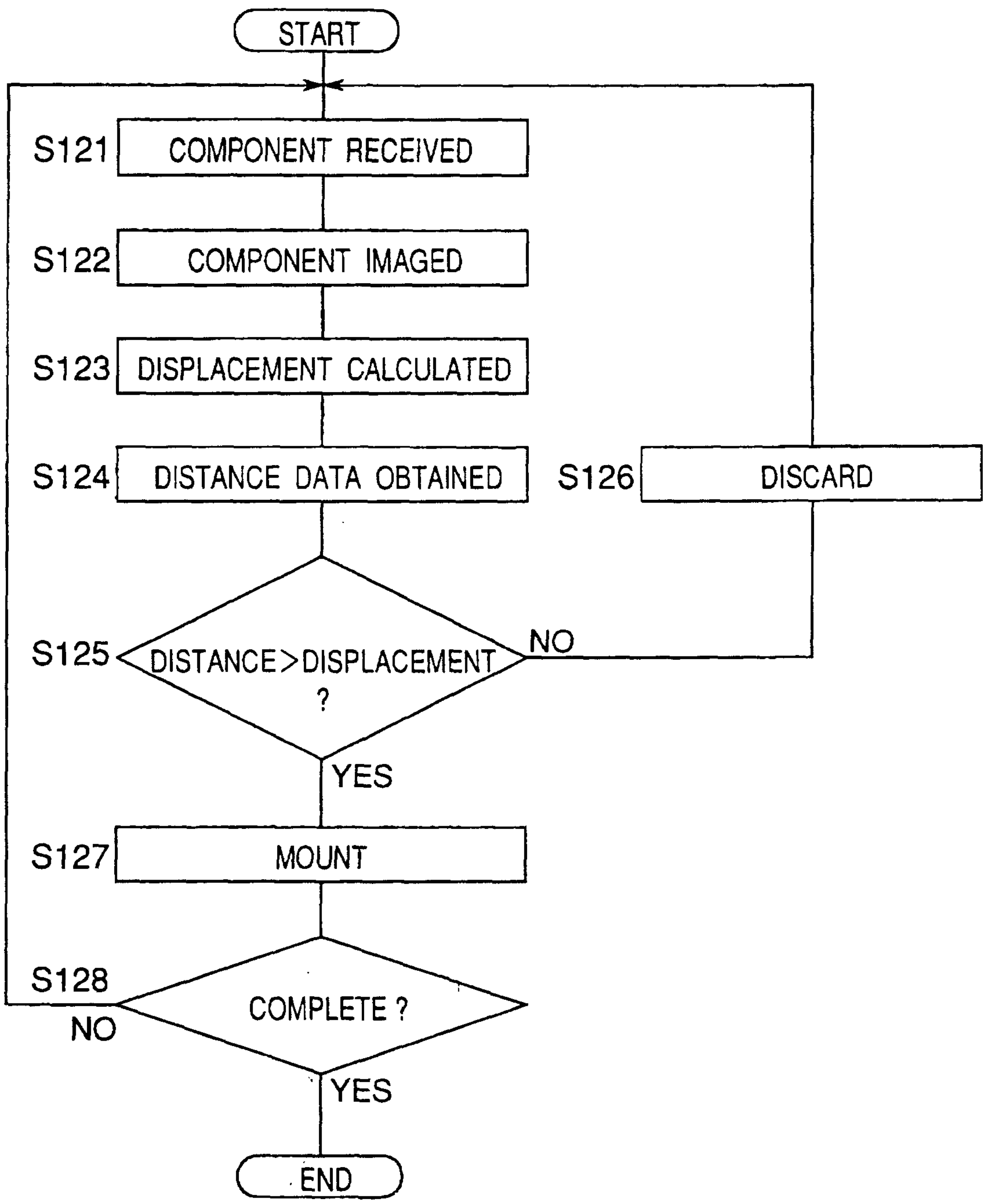
START
S121
COMPONENT RECEIVED
S122
COMPONENT IMAGED
S123
DISPLACEMENT CALCULATED
S124
DISTANCE DATA OBTAINED
S126
DISCARD
S125
DISTANCE>DISPLACEMENT ?
NO
YES
S127
MOUNT
S128
COMPLETE ?
NO
YES
END

Fig.26

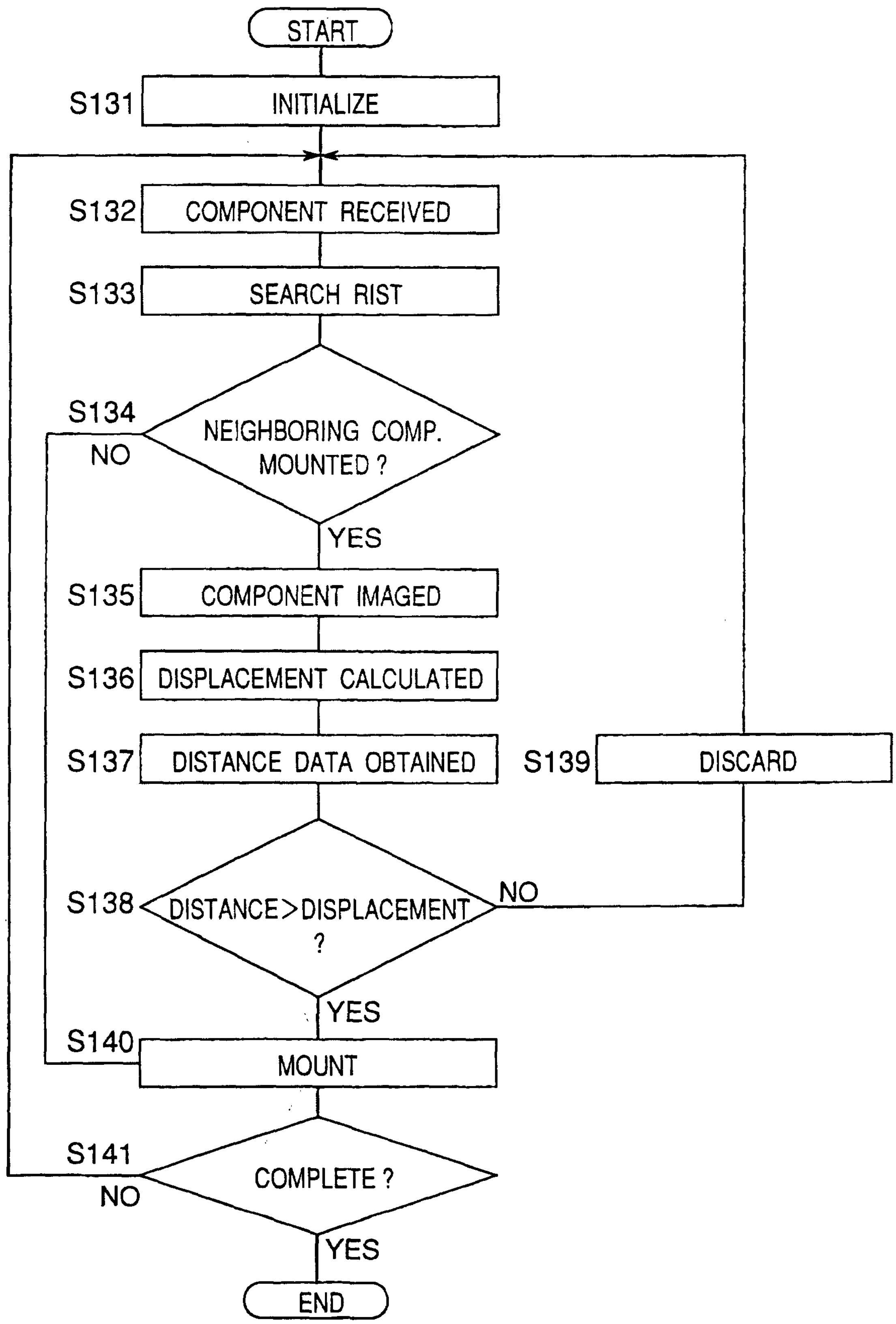
START
S131
INITIALIZE
S132
COMPONENT RECEIVED
S133
SEARCH RIST
S134
NEIGHBORING COMP. MOUNTED ?
NO
YES
S135
COMPONENT IMAGED
S136
DISPLACEMENT CALCULATED
S137
DISTANCE DATA OBTAINED
S139
DISCARD
S138
DISTANCE>DISPLACEMENT ?
NO
YES
S140
MOUNT
S141
COMPLETE ?
NO
YES
END

Fig. 27

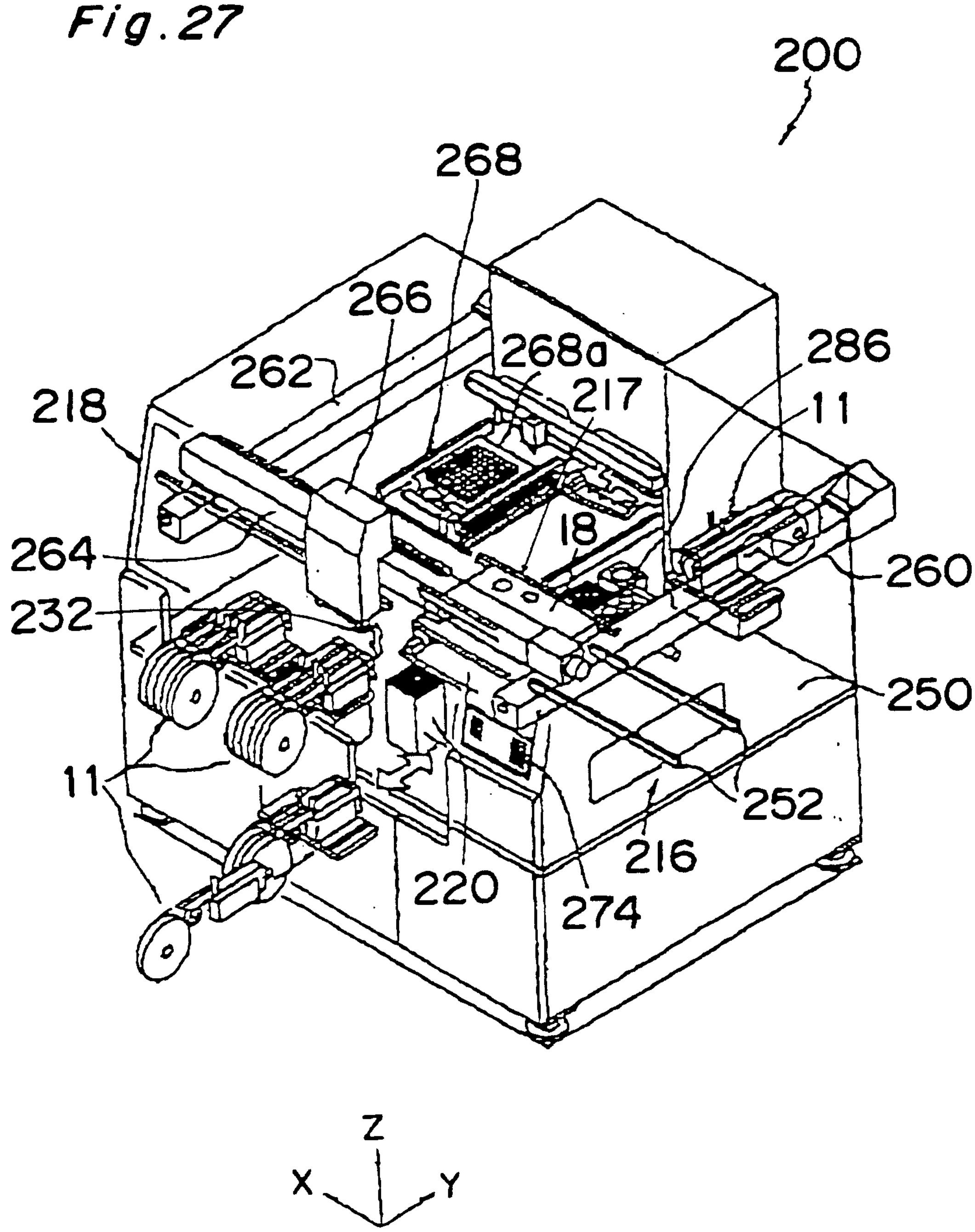
200
268
266
268a
286
262
217
218
11
18
264
260
232
250
11
252
216
220
274
Z
X
Y

Fig.28

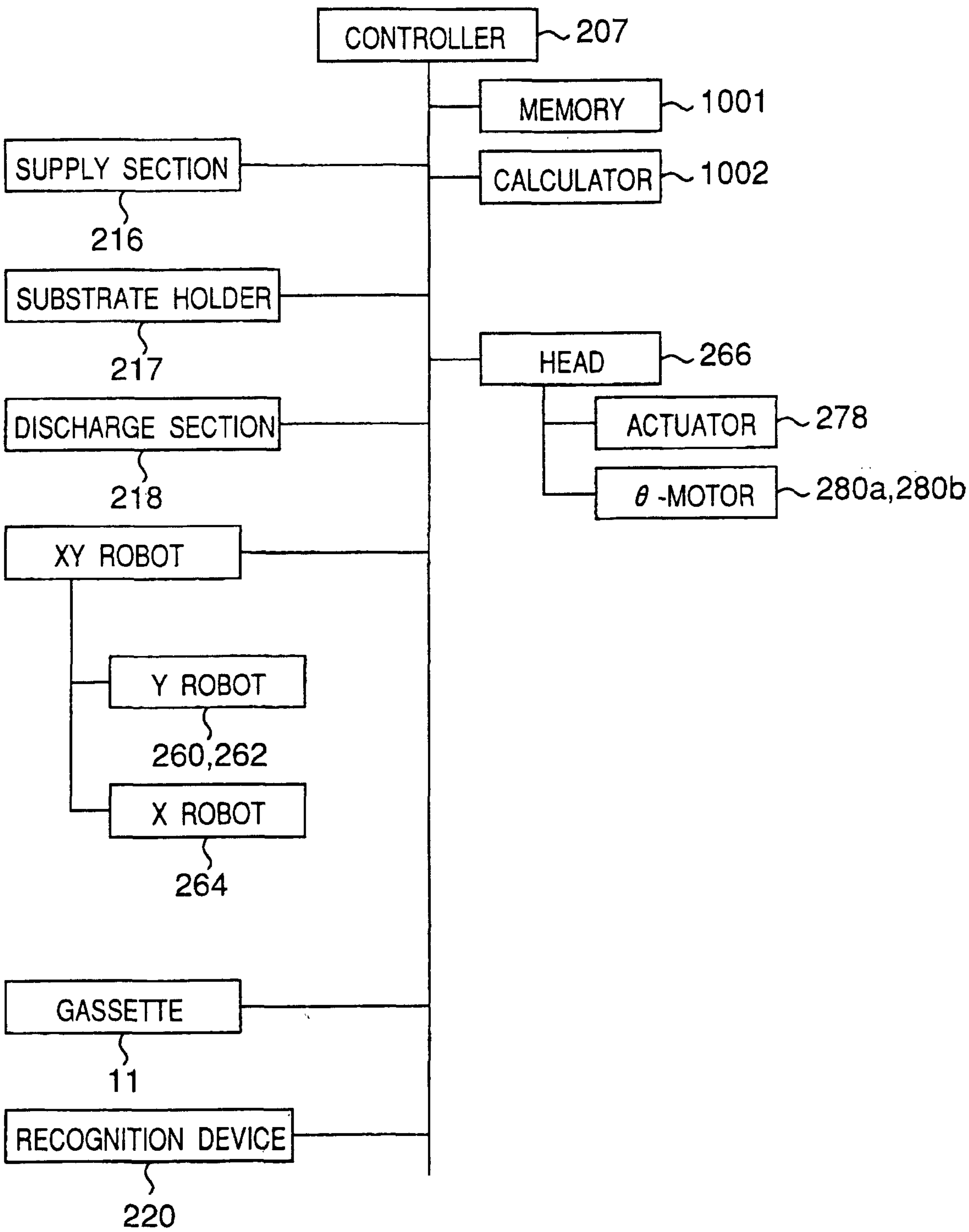
CONTROLLER
207
MEMORY
1001
CALCULATOR
1002
SUPPLY SECTION
216
SUBSTRATE HOLDER
217
HEAD
266
ACTUATOR
278
DISCHARGE SECTION
218
θ -MOTOR
280a,280b
XY ROBOT
Y ROBOT
260,262
X ROBOT
264
GASSETTE
11
RECOGNITION DEVICE
220

Fig.29

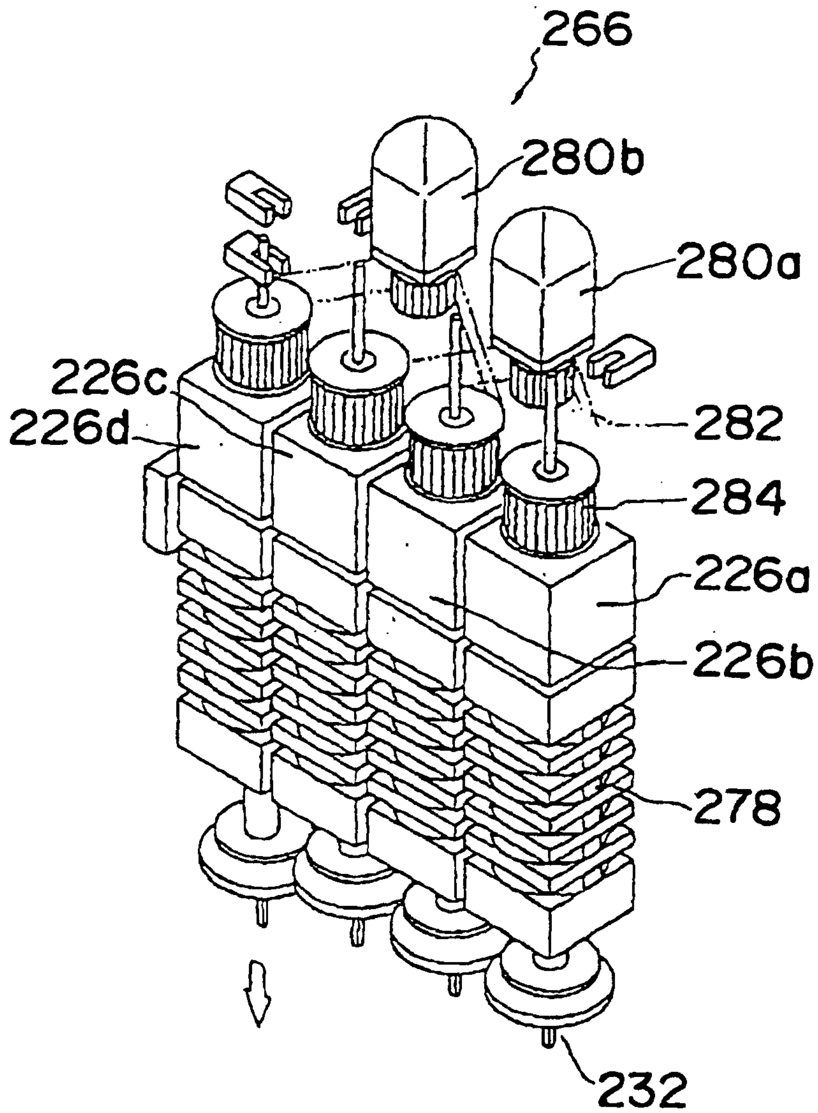

Fig. 30

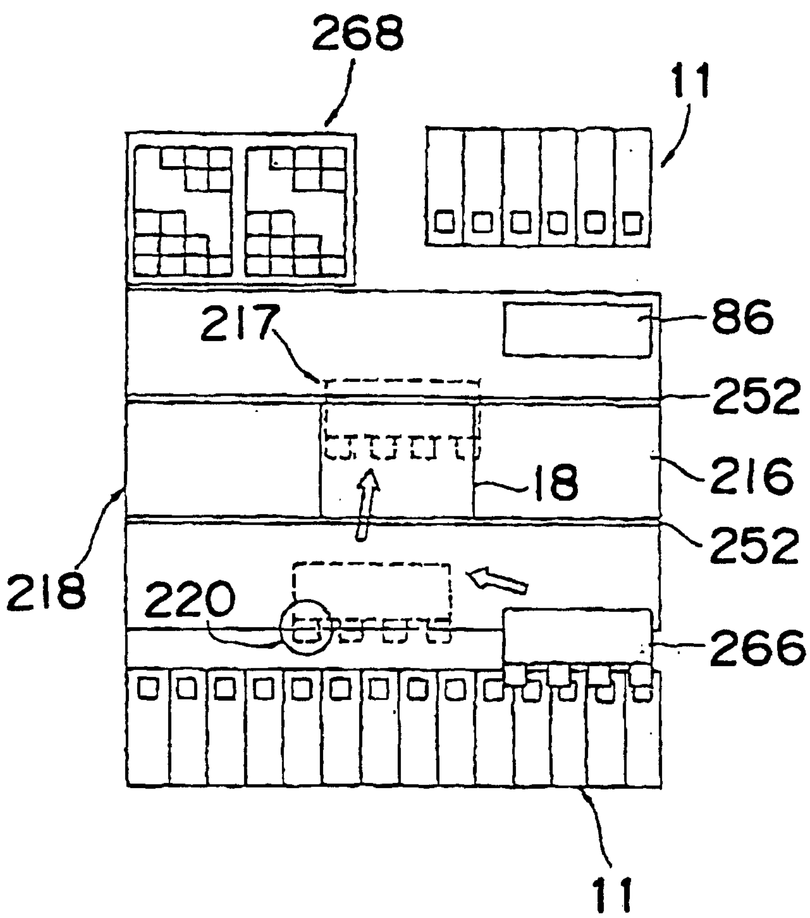

Fig.31 PRIOR ART

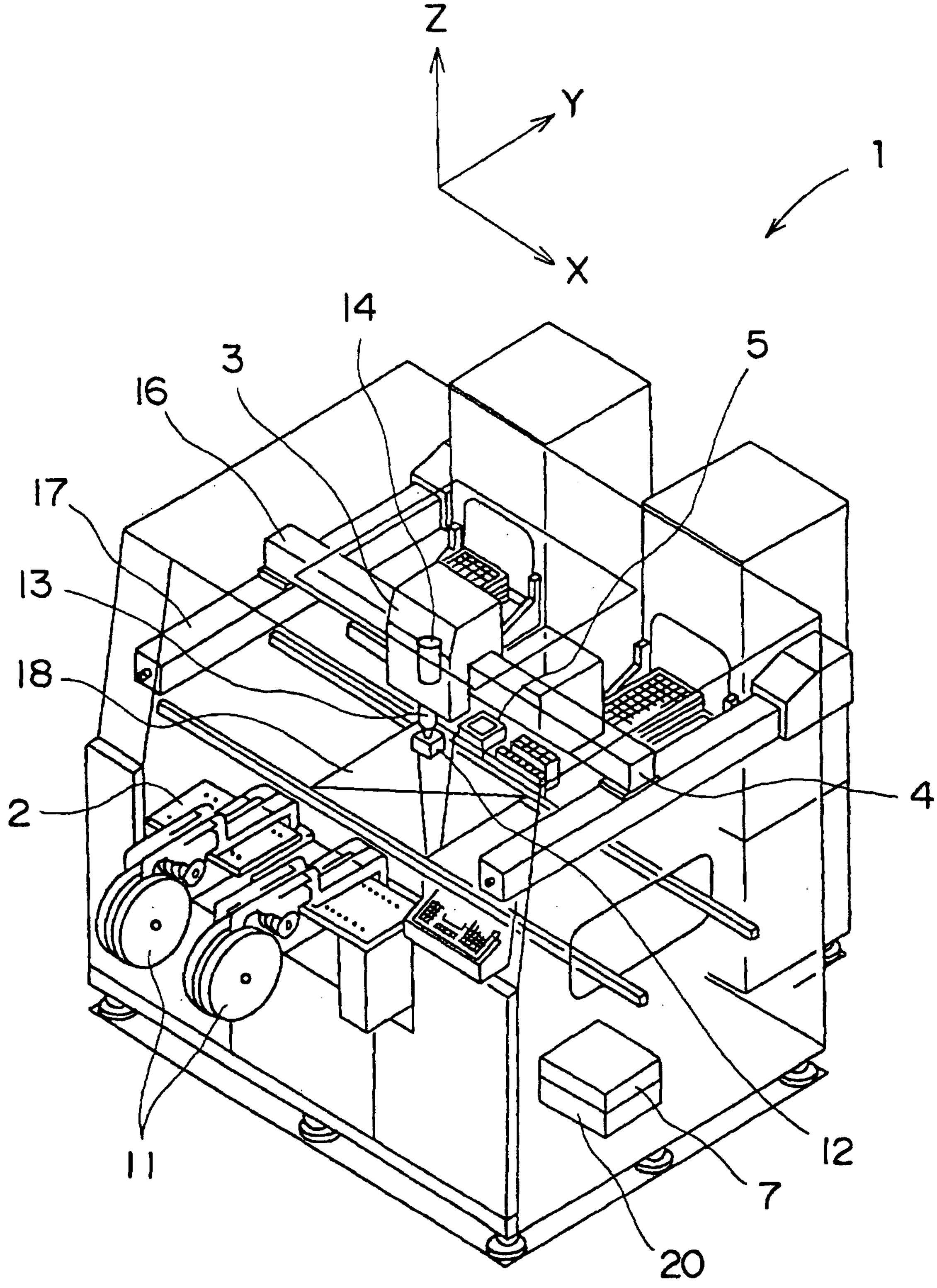

Fig.32 PRIOR ART

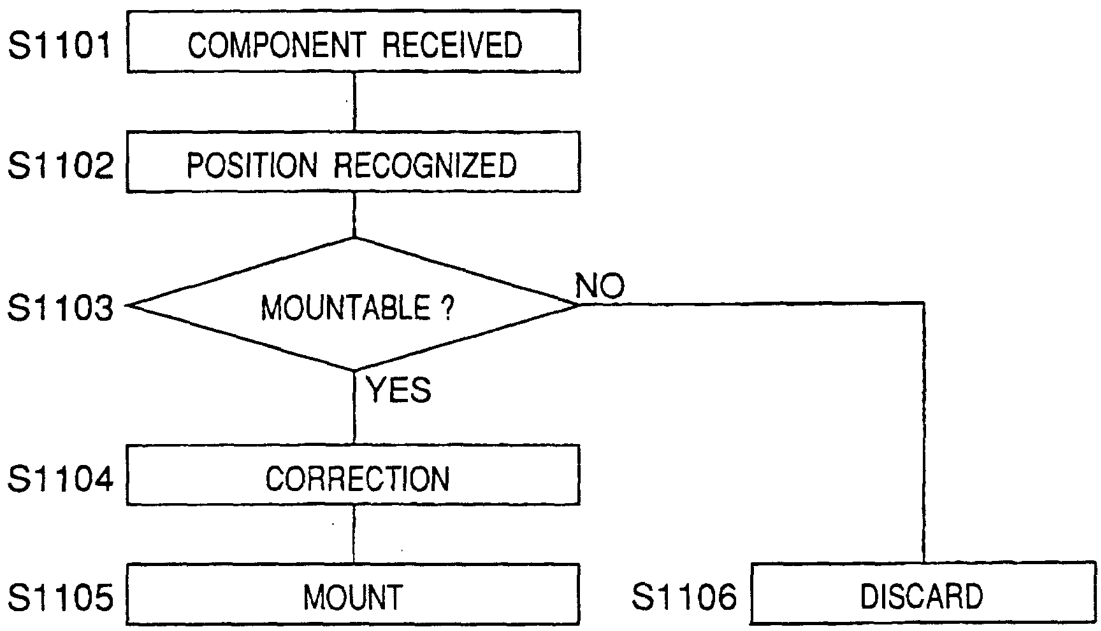

*Fig.33A*
*PRIOR ART*

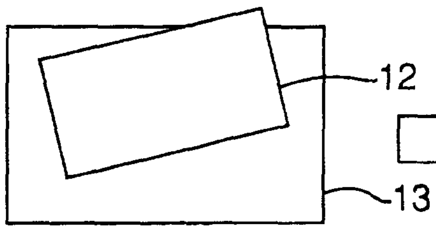


*Fig.33B*
*PRIOR ART*

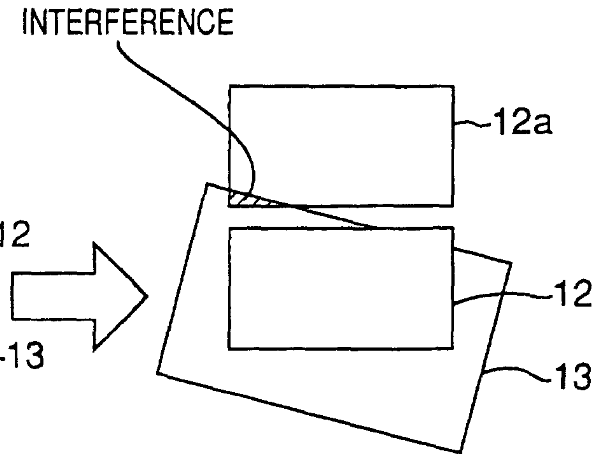


*Fig.34A*
*PRIOR ART*

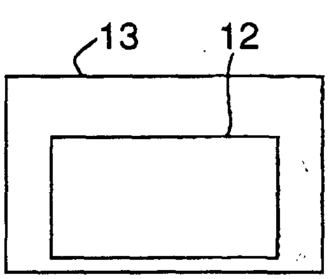


*Fig.34B*
*PRIOR ART*